# EUROPEAN PATENT APPLICATION

(11) **EP 4 203 646 A1**
(43) Date of publication of application: **28.06.2023**
(21) Application number: 22215874.3
(22) Date of filing: 22.12.2022
(51) Int. Cl.: H10K 50/13

(54) **LIGHT-EMITTING DEVICE AND ELECTRONIC APPARATUS INCLUDING THE SAME**

(30) Priority: 23.12.2021 KR 20210186588
(71) Applicant: Samsung Display Co., Ltd., Yongin-si, Gyeonggi-do 17113 (KR)
(72) Inventor: Lee, Yoonkyoo, 17113 Giheung-gu, Yongin-si, Gyeonggi-do (KR); Sun, Jinwon, 17113 Giheung-gu, Yongin-si, Gyeonggi-do (KR); Chu, Changwoong, 17113 Giheung-gu, Yongin-si, Gyeonggi-do (KR)
(74) Representative: Dr. Weitzel & Partner

(57) **Abstract**

A light-emitting device and an electronic apparatus including the same are provided. The light-emitting device includes an emission layer that includes a first emission layer and a second emission layer.

## Description

### BACKGROUND

### 1. Field

Aspects of one or more embodiments of the present disclosure relate to a light-emitting device and an electronic apparatus including the same.

The preamble of the device in question comprises a light-emitting device comprising a first electrode, a second electrode facing the first electrode, and an interlayer between the first electrode and the second electrode and comprising an emission layer.

### 2. Description of the Related Art

Self-emissive devices among light-emitting devices have wide viewing angles, high contrast ratios, short response times, and excellent or suitable characteristics in terms of luminance, driving voltage, and response speed.

In a light-emitting device, a first electrode is on a substrate, and a hole transport region, an emission layer, an electron transport region, and a second electrode are sequentially disposed on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons are transitioned from an excited state to a ground state to thereby generate light.

### SUMMARY

Aspects of one or more embodiments of the present disclosure are directed toward a light-emitting device and an electronic apparatus including the same.

Additional aspects of embodiments of the present disclosure will be set forth in part in the disclosure which follows and, in part, will be apparent from the disclosure, or may be learned by practice of the presented embodiments of the disclosure.

According to one or more embodiments, a light-emitting device includes
a first electrode,
a second electrode facing the first electrode, and
an interlayer arranged between the first electrode and the second electrode and including an emission layer,
wherein the emission layer includes a first emission layer and a second emission layer,
the first emission layer includes a first host including a first-first host and a first-second host, but does not include a dopant (e.g., the dopant of the second emission layer or any dopant),
the second emission layer includes a second host and a dopant, the second host including a second-first host and a second-second host,
the first-first host and the first-second host are different from each other,
the second-first host and the second-second host are different from each other, and
a triplet energy level of the first host (T_{H1}) is greater than a triplet energy level of the second host (T_{H2}).

According to one or more embodiments, an electronic apparatus includes the light-emitting device.

### BRIEF DESCRIPTION OF THE DRAWINGS

The above and other aspects and features of certain embodiments of the disclosure will be more apparent from the following description taken in conjunction with the accompanying drawings, in which:
FIG. 1 shows a schematic view of a light-emitting device according to an embodiment;
FIG. 2 shows a cross-sectional view of an electronic apparatus according to an embodiment; and
FIG. 3 shows a cross-sectional view of an electronic apparatus according to another embodiment.

### DETAILED DESCRIPTION

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described, by referring to the drawings, to explain aspects of embodiments of the present disclosure. As utilized herein, the term "and/or" includes any and all combinations of one or more of the associated listed items. Throughout the disclosure, the expression "at least one of a, b and c" indicates only a, only b, only c, both (e.g., simultaneously) a and b, both (e.g., simultaneously) a and c, both (e.g., simultaneously) b and c, all of a, b, and c, or variations thereof.

A light emitting device as per claim 1 is expected to have excellent or suitable efficiency and a long life span. Such is, however, not always the case.
The problem will be solved by a device as per claim 1 ("the invention") which reads as follows: A light-emitting device including: a first electrode; a second electrode facing the first electrode; and an interlayer arranged between the first electrode and the second electrode and including an emission layer, wherein the emission layer includes a first emission layer and a second emission layer, the first emission layer includes a first host including a first-first host and a first-second host, and does not include a dopant (e.g., does not include the dopant of the second emission laye or does not include any dopant), the second emission layer includes a second host and a dopant, the second host including a second-first host and a second-second host, the first-first host and the first-second host are different from each other, the second-first host and the second-second host are different from each other, a triplet energy level of the first host (T_{H1}) is greater than a triplet energy level of the second host (T_{H2}).

The triplet energy level of the first host T_{H1} may refer to the triplet energy level of a host mixture (e.g., a first host mixture) including both (e.g., simultaneously) the first-first host and the first-second host.

The triplet energy level of the second host T_{H2} may refer to the triplet energy level of a host mixture (e.g., a second host mixture) including both (e.g., simultaneously) the second-first host and the second-second host.

For example, the triplet energy level of the first host T_{H1} may be calculated from the starting point of the shortest wavelength from a low-temperature emission spectrum of a mixed deposition layer formed by the first-first host and the first-second host (250 Å + 250 Å).

For example, the triplet energy level of the second host T_{H2} may be calculated from the starting point of the shortest wavelength from a low-temperature emission spectrum of a mixed deposition layer formed by the second-first host and the second-second host (250 Å + 250 Å).

In an embodiment, triplet excitons formed in the first emission layer may migrate from the first emission layer to the second emission layer. For example, when the triplet energy level of the first host T_{H1} is greater than the triplet energy level of the second host T_{H2}, the triplet excitons formed in the first emission layer may migrate from the first emission layer to the second emission layer. For example, when the triplet excitons formed in the first emission layer migrate to the second emission layer, the triplet excitons may be converted into an emission energy of the dopant included in the second emission layer.

In an embodiment, migration of triplet excitons formed in the second emission layer from the second emission layer to the first emission layer may be limited. For example, when the triplet energy level of the second host T_{H2} is greater than the triplet energy level of the first host T_{H1}, the migration of the triplet excitons formed in the second emission layer from the second emission layer to the first emission layer may be limited.

In an embodiment, the first-first host, the first-second host, the second-first host, and the second-second host may each independently be represented by Formula 1:

**Formula 1** **[Ar₁₁]_{c11}-[(L₁₁)ₐ₁₁-R₁₁]_{b11}**

wherein, in Formula 1,
Ar₁₁ and L₁₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
a11 and c11 may each be an integer from 0 to 3,
R₁₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
b11 may be an integer from 1 to 5,
R₁₀ₐ may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁₎(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or one or more combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof; a C₇-C₆₀ arylalkyl group; or a C₂-C₆₀ heteroarylalkyl group.

In an embodiment, an electron-transporting moiety may be included in: one selected from the first-first host and the first-second host; and one selected from the second-first host and the second-second host.

In one or more embodiments, the electron-transporting moiety may be included in the first-second host and the second-second host.

In an embodiment, the electron-transporting moiety may include a cyano group, a fluorine, a π-electron deficient nitrogen-containing C₁-C₆₀ cyclic group, or one or more combinations thereof.

For example, the π-electron deficient nitrogen-containing C₁-C₆₀ cyclic group may include a heterocyclic group including at least one *-N=*' moiety as a ring-forming moiety.

In an embodiment, the first-first host and the second-first host may each be a hole-transporting host, and the first-second host and the second-second host may each be an electron-transport host.

For example, the hole-transporting host may include at least one of Compound 1-1 and Compound 1-2:

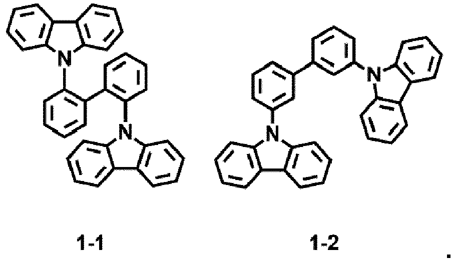

For example, the electron-transporting host may include at least one of Compound 2-1, Compound 2-2, and Compound 2-3:

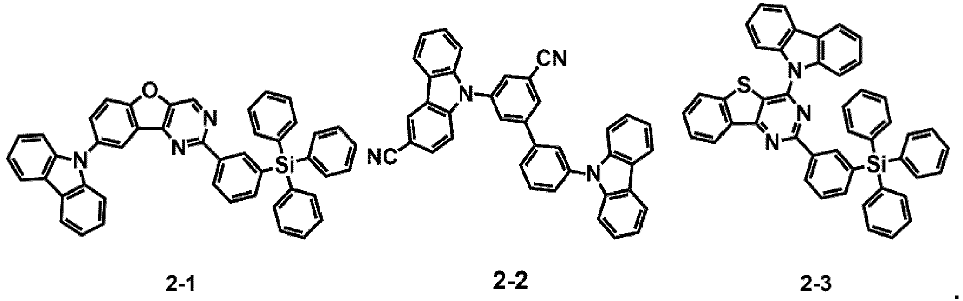

In an embodiment, the first-first host and the second-first host may be identical to each other, and the first-second host and the second-second host may be different from each other.

In one or more embodiments, the first-first host and the second-first host may be different from each other, and the first-second host and the second-second host may be identical to each other.

In one or more embodiments, the first-first host and the second-first host may be different from each other, and the first-second host and the second-second host may be also different from each other.

In an embodiment, an amount ratio of the first-second host to the first-first host included in the first host may be in a range of about 1:0.1 to about 1:10. For example, the amount ratio of the first-second host to the first-first host included in the first host may be in a range of about 1:0.5 to about 1:2.

In an embodiment, an amount ratio of the second-second host to the second-first host included in the second host may be in a range of about 1:0.1 to about 1:10. For example, the amount ratio of the second-second host to the second-first host included in the second host may be in a range of about 1:0.5 to about 1:2.

In an embodiment, the dopant may be a phosphorescent dopant.

In an embodiment, the dopant may be represented by Formula 3:

**Formula 3** **M₃(L₃₁)ₐ₃₁(L₃₂)ₐ₃₂**

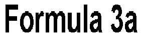

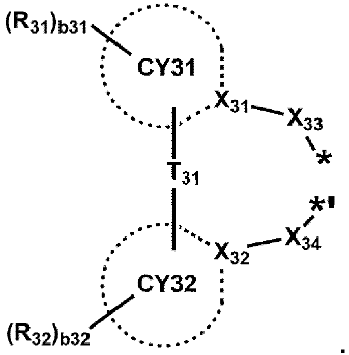

In Formulae 3 and 3a, M₃ may be iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm).

In an embodiment, in Formula 3, M₃ may be Ir or Pt. In an embodiment, in Formula 3, M₃ may be Pt.

In Formula 3, L₃₁ may be a ligand represented by Formula 3a.

In Formula 3, a31 may be an integer from 1 to 3. Here, a31 indicates the number of L₃₁(s). When a31 is an integer of 2 or greater, two or more of L₃₁ may be identical to or different from each other.

In Formulae 3 and 3a, when a31 is 2 or more, two ring CY31(s) in two or more of L₃₁(s) may optionally be linked to each other via T₃₂, which is a linking group, or two ring CY32(s) in two or more of L₃₁(s) may optionally be linked to each other via T₃₃, which is a linking group.

In Formula 3, L₃₂ may be an organic ligand.

In an embodiment, the organic ligand may include a halogen group, a diketone group, a carboxylic acid group, -C(=O) group, an isonitrile group, a -CN group, a phosphorus containg group, or one or more combinations thereof.

In Formula 3, a32 may be an integer from 1 to 3. Here, a32 indicates the number of L₃₂(s). When a32 is an integer of 2 or greater, two or more of L₃₂ may be identical to or different from each other.

In Formula 3a, X₃₁ and X₃₂ may each independently be nitrogen or carbon.

In an embodiment, X₃₁ and X₃₂ in Formula 3a may satisfy one of Conditions 3-1 to 3-3:
Condition 3-1
   X₃₁ is nitrogen, and X₃₂ is carbon;
Condition 3-2
   X₃₁ is carbon, and X₃₂ is carbon; and
Condition 3-3
   X₃₁ is nitrogen, and X₃₂ is nitrogen.

In an embodiment, X₃₁ and X₃₂ in Formula 3a may satisfy Condition 3-1 or Condition 3-2.

In Formula 3a, ring CY31 and ring CY32 may each independently be a C₃-C₆₀ carbocyclic group or a C₁-C₆₀ heterocyclic group.

In an embodiment, in Formula 3a, ring CY31 and ring CY32 may each independently be a benzene group, a naphthalene group, an anthracene group, a phenanthrene group, an imidazole group, a pyrazole group, a pyridine group, a pyrimidine group, a pyridoindole group, a benzimidazole group, a carbazole group, a dibenzofuran group, a fluorene group, a dibenzothiophene group, or a dibenzosilole group.

In one or more embodiments, in Formula 3a, ring CY31 and ring CY32 may each independently be a benzene group, an imidazole group, a pyrazole group, a pyridine group, a pyrimidine group, a pyridoindole group, a benzimidazole group, or a carbazole group.

In Formula 3a, T₃₁ to T₃₃ may each independently be a single bond, *"-O-*‴, *"-S-*‴, *"-C(=O)-*‴, *"-N(Z₃₁)-*‴, *"-C(Z₃₁)(Z₃₂)-*‴, *"-C(Z₃₁)=C(Z₃₂)-*‴, *"-C(Z₃₁)=*‴, or *"=C=*‴, wherein *" and *‴ each indicate a binding site to a neighboring atom.

X₃₃ and X₃₄ may each independently be a covalent bond, a coordinate bond, O, S, N(Z₃₃), B(Z₃₃), P(Z₃₃), C(Z₃₃)(Z₃₄), or Si(Z₃₃)(Z₃₄).

*" and *‴ each indicate a binding site to a neighboring atom.

In an embodiment, in Formula 3a, T₃₁ to T₃₃ may each independently be a single bond or *"-O-*‴.

In Formula 3a, R₃₁, R₃₂, and Z₃₁ to Z₃₄ may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂).

In Formula 3a, b31 and b32 may each independently be an integer from 0 to 10.
b31 and b32 indicate the number of R₃₁(s) and the number of R₃₂(s), respectively. When b31 is an integer of 2 or greater, two or more of R₃₁(s) may be identical to or different from each other. When b32 is an integer of 2 or greater, two or more of R₃₂(s) may be identical to or different from each other.

Two R₃₁(s) among two or more of R₃₁(s) when b31 is an integer of 2 or more; two R₃₂(s) among two or more of R₃₂(s) when b32 is an integer of 2 or more; or R₃₁ and R₃₂, may optionally be linked to each other to form a C₃-C₆₀ carbocyclic group unsubstituted or substituted with at least one R₁₀ₐ or a C₁-C₆₀ heterocyclic group unsubstituted or substituted with at least one R₁₀ₐ.

In Formula 3a, * and *' each indicate a binding site to M₃ in Formula 3.

In Formulae 3 and 3a, R₁₀ₐ may be: deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or one or more combinations thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or one or more combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof; a C₇-C₆₀ arylalkyl group; or a C₂-C₆₀ heteroarylalkyl group.

For example, the dopant may include at least one of Compounds 3-1 and 3-2:

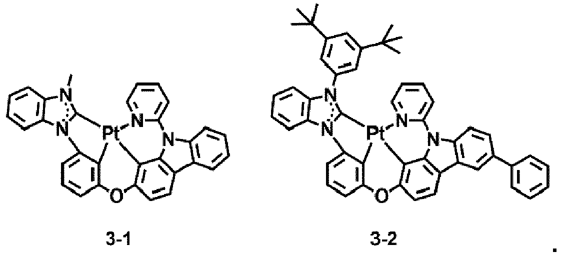

In the light-emitting device, the emission layer may include the first emission layer and the second emission layer. The first emission layer may include the first host including the first-first host and the first-second host, and may not include (e.g., may exclude) a dopant (e.g., may not include any dopant or the dopant of the second emission layer). The second emission layer may include the second host and the dopant, the second host including the second-first host and the second-second host. Here, the first-first host and the first-second host may be different from each other, and the second-first host and the second-second host may be different from each other. The triplet energy level of the first host T_{H1} may be greater than the triplet energy level of the second host T_{H2}.

Although not intended to be limited by a particular theory, in the light-emitting device disclosed herein, the first host included in the first emission layer and the second host included in the second emission layer satisfy a specific condition regarding the triplet energy level, and thus the triplet excitons formed in the first emission layer may easily migrate to the second emission layer. In some embodiments, the migration of the triplet excitons formed in the second emission layer to the first emission layer may be suppressed or reduced.

Thus, an additional reaction, such as a triplet-triplet or triplet-polaron interaction may be prevented or reduced, thereby improving (increasing) a lifespan of the light-emitting device. In some embodiments, the excitons formed in the first emission layer may migrate to the second emission layer, and then may be converted into the emission energy of the dopant included in the second emission layer, thereby improving efficiency of the light-emitting device. Accordingly, an electronic apparatus including the light-emitting device may have improved (increased) luminescence efficiency and/or a long lifespan.

Synthesis methods of the compound represented by Formula 1 and the compound represented by Formula 3 may be recognized by those of ordinary skill in the art by referring to Examples described herein.

In an embodiment, the light-emitting device may include:
the first electrode;
the second electrode facing the first electrode; and
the interlayer arranged between the first electrode and the second electrode and including the emission layer,
wherein the emission layer includes the first emission layer and the second emission layer,
the first emission layer includes the first host including the first-first host and the first-second host, but does not include the dopant,
the second emission layer includes the second host and the dopant, the second host including the second-first host and the second-second host,
the first-first host and the first-second host are different from each other,
the second-first host and the second-second host are different from each other, and
the triplet energy level of the first host T_{H1} is greater than the triplet energy level of the second host T_{H2}.

In an embodiment,
the first electrode of the light-emitting device may be an anode,
the second electrode of the light-emitting device may be a cathode, and
the interlayer may further include a hole transport region arranged between the first electrode and the emission layer and an electron transport region arranged between the emission layer and the second electrode.

The hole transport region may include a hole injection layer, a hole transport layer, an emission auxiliary layer, an electron blocking layer, or one or more combinations thereof.

The electron transport region may include a buffer layer, a hole blocking layer, an electron control layer, an electron transport layer, an electron injection layer, or one or more combinations thereof.

In an embodiment, the light-emitting device may satisfy Condition 1 or Condition 2:
Condition 1
   the first emission layer is arranged between the first electrode and the second emission layer, and
   the second emission layer is arranged between the first emission layer and the second electrode; and
Condition 2
   the first emission layer is arranged between the second electrode and the second emission layer, and
   the second emission layer is arranged between the first emission layer and the first electrode.

In an embodiment, the light-emitting device may satisfy Condition 1. In an embodiment, the light-emitting device may satisfy Condition 2.

In one or more embodiments, the light-emitting device may include a plurality of first emission layers, and may satisfy both (e.g., simultaneously) Conditions 1 and 2.

In an embodiment, the light-emitting device may satisfy Condition 1-1 or Condition 2-1:
Condition 1-1
   the first emission layer is arranged between the hole transport region and the second emission layer, and the second emission layer is arranged between the electron transport region and the first emission layer; and
Condition 2-1
   the first emission layer is arranged between the electron transport region and the second emission layer, and the second emission layer is arranged between the hole transport region and the first emission layer.

In an embodiment, the light-emitting device may satisfy Condition 1-1. In an embodiment, the light-emitting device may satisfy Condition 2-1.

In one or more embodiments, the light-emitting device may include a plurality of first emission layers, and may satisfy both (e.g., simultaneously) Conditions 1-1 and 2-1.

In an embodiment, the light-emitting device may satisfy Condition 1-2 or Condition 2-2:
Condition 1-2
   the first emission layer is arranged between the electron blocking layer and the second emission layer, and the second emission layer is arranged between the hole blocking layer and the first emission layer; and
Condition 2-2
   the first emission layer is arranged between the hole blocking layer and the second emission layer, and the second emission layer is arranged between the electron blocking layer and the first emission layer.

In an embodiment, the light-emitting device may satisfy Condition 1-2. In an embodiment, the light-emitting device may satisfy Condition 2-2.

In one or more embodiments, the light-emitting device may include a plurality of first emission layers, and may satisfy both (e.g., simultaneously) Conditions 1-2 and 2-2.

In an embodiment, the first emission layer may be in direct contact with the second emission layer.

In an embodiment, triplet excitons formed in the first emission layer may migrate from the first emission layer to the second emission layer.

In one or more embodiments, the migration of triplet excitons formed in the second emission layer from the second emission layer to the first emission layer may be limited.

In an embodiment, the emission layer may emit red light, green light, blue light, and/or white light.

For example, the emission layer may emit blue light. The blue light may have, for example, a maximum emission wavelength in a range of about 400 nm to about 490 nm. The blue light may have, for example, a maximum emission wavelength in a range of, for example, about 440 nm to about 480 nm.

In an embodiment, the second emission layer may emit red light, green light, blue light, and/or white light.

For example, the second emission layer may emit blue light. The blue light may have, for example, a maximum emission wavelength in a range of about 400 nm to about 490 nm. The blue light may have, for example, a maximum emission wavelength in a range of, for example, about 440 nm to about 480 nm.

For example, the first emission layer may further include another host in addition to the first host. For example, the second emission layer may further include another host, in addition to the second host.

In one or more embodiments, the emission layer may further include a dopant. In an embodiment, the dopant may further include a phosphorescent dopant, a delayed fluorescence material, or a combination thereof. For example, the emission layer may further include a phosphorescent dopant, in addition to a host and a dopant represented by Formula 3. However, the first emission layer may not include (e.g., may exclude) the dopant (e.g., does not include any dopant). For example, the first emission layer may not include (e.g., may exclude) a phosphorescent dopant, a delayed fluorescence material, or any combination thereof.

In one or more embodiments, the second emission layer may further include a dopant. In an embodiment, the dopant may further include a phosphorescent dopant, a delayed fluorescence material, or any combination thereof. For example, the second emission layer may further include a dopant, in addition to a host and a dopant represented by Formula 3.

For example, the dopant may include a transition metal and ligand(s) in the number of m, wherein m may be an integer from 1 to 6. The ligand(s) in the number of m may be identical to or different from each other, at least one of the ligand(s) in the number of m may be linked to the transition metal via a carbon-transition metal bond, and the carbon-transition metal bond may be a coordinate bond. For example, at least one of the ligand(s) in the number of m may be a carbene ligand (for example, Ir(pmp)3 and/or the like). The transition metal may be, for example, Ir, Pt, Os, Pd, Rh, or Au. The emission layer and the dopant may be the same as described in the present disclosure.

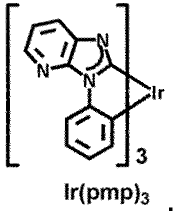

In one or more embodiments, the light-emitting device may include a capping layer arranged outside the first electrode or outside the second electrode.

For example, the light-emitting device may further include at least one selected from a first capping layer arranged outside the first electrode and a second capping layer arranged outside the second electrode. More details on the first capping layer and/or second capping layer may each independently be the same as described in the present disclosure.

The expression "(interlayer and/or electron transport layer) includes a compound represented by Formula 1" as utilized herein may be understood as "(interlayer and/or electron transport layer) may include one kind of compound represented by Formula 1 or two or morekinds of compounds, each represented by Formula 1."

For example, the first emission layer may include the first host. For example, the first emission layer may include the first-first host and the first-second host. For example, the second emission layer may include the second host. For example, the second emission layer may include the second-first host and the second-second host.

The term "interlayer" as utilized herein refers to a single layer and/or all of a plurality of layers arranged between the first electrode and the second electrode of the light-emitting device.

Another aspect of embodiments provides an electronic apparatus including the light-emitting device. The electronic apparatus may further include a thin-film transistor. For example, the electronic apparatus may further include a thin-film transistor including a source electrode and a drain electrode, wherein the first electrode of the light-emitting device may be electrically connected to the source electrode or the drain electrode. In an embodiment, the electronic apparatus may further include a color filter, a color conversion layer, a touch screen layer, a polarizing layer, or one or more combinations thereof. More details on the electronic apparatus may each independently be the same as described in the present disclosure.

### Description of FIG. 1

FIG. 1 is a schematic cross-sectional view of a light-emitting device 10 according to an embodiment. The light-emitting device 10 includes a first electrode 110, an interlayer 130, and a second electrode 150. The interlayer 130 may include an emission layer. The emission layer may include a first emission layer and a second emission layer.

Hereinafter, the structure of the light-emitting device 10 according to an embodiment and a method of manufacturing the light-emitting device 10 will be described with reference to FIG. 1.

### First electrode 110

In FIG. 1, a substrate may be additionally arranged under the first electrode 110 or on the second electrode 150. As the substrate, a glass substrate or a plastic substrate may be utilized. In an embodiment, the substrate may be a flexible substrate, and may include plastics with excellent or suitable heat resistance and durability, such as polyimide, polyethylene terephthalate (PET), polycarbonate, polyethylene napthalate, polyarylate (PAR), polyetherimide, or one or more combinations thereof.

The first electrode 110 may be formed by, for example, depositing or sputtering a material for forming the first electrode 110 on the substrate. When the first electrode 110 is an anode, a material for forming the first electrode 110 may be a highwork function material that facilitates injection of holes.

The first electrode 110 may be a reflective electrode, a semi-transmissive electrode, or a transmissive electrode. In an embodiment, when the first electrode 110 is a transmissive electrode, a material for forming the first electrode 110 may include indium tin oxide (ITO), indium zinc oxide (IZO), tin oxide (SnO₂), zinc oxide (ZnO), or one or more combinations thereof. In one or more embodiments, when the first electrode 110 is a semi-transmissive electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesiumsilver (Mg-Ag), or one or more combinations thereof.

The first electrode 110 may have a single-layered structure including (e.g., consisting of) a single layer or a multi-layered structure including a plurality of layers. For example, the first electrode 110 may have a three-layered structure of ITO/Ag/ITO.

### Interlayer 130

The interlayer 130 may be arranged on the first electrode 110. The interlayer 130 may include an emission layer. The emission layer may include the first emission layer and the second emission layer.

The interlayer 130 may further include a hole transport region arranged between the first electrode 110 and the emission layer and an electron transport region arranged between the emission layer and the second electrode 150.

The interlayer 130 may further include, in addition to one or more suitable organic materials, a metal-containing compound such as an organometallic compound, an inorganic material such as a quantum dot, and/or the like.

In an embodiment, the interlayer 130 may include, i) two or more emitting units sequentially stacked between the first electrode 110 and the second electrode 150, and ii) a charge generation layer arranged among the two or more emitting units. When the interlayer 130 includes the two or more emitting units and the charge generation layer, the light-emitting device 10 may be a tandem light-emitting device.

### Hole transport region in interlayer 130

The hole transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The hole transport region may include a hole injection layer, a hole transport layer, an emission auxiliary layer, an electron blocking layer, or one or more combinations thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein the layers of each structure are stacked sequentially from the first electrode 110.

The hole transport region may further include a compound represented by Formula 201, a compound represented by Formula 202, or any combination thereof:

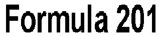

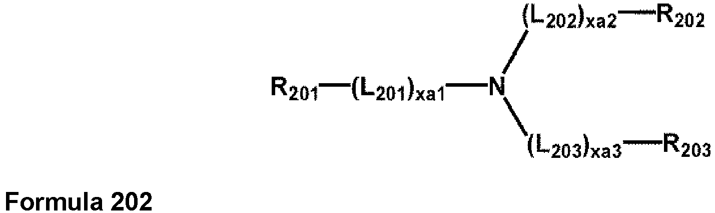

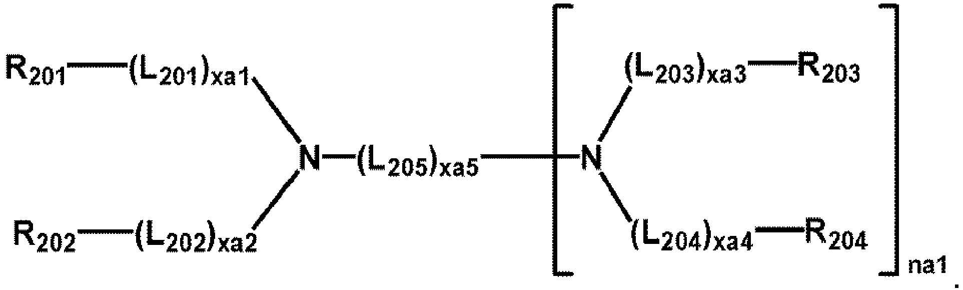

In Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ, or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group (for example, a carbazole group and/or the like) unsubstituted or substituted with at least one R₁₀ₐ (for example, Compound HT16),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, each of Formulae 201 and 202 may include at least one of groups represented by Formulae CY201 to CY217:

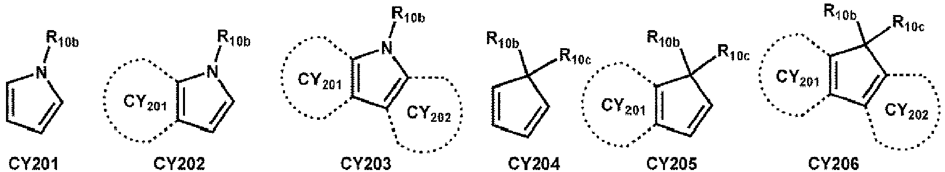

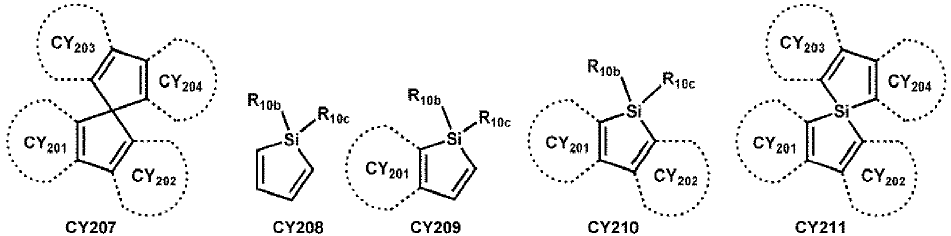

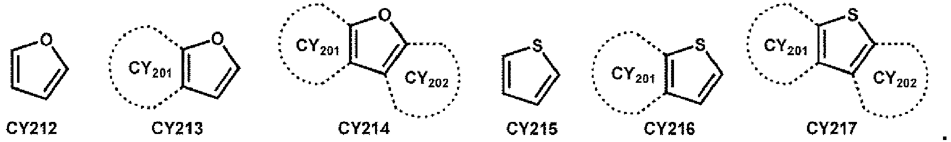

In Formulae CY201 to CY217, R_{10b} and R_{10c} may each be the same as described with respect to R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ as described above.

In an embodiment, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one of the groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, R₂₀₁ may be a group represented by one of Formulae CY201 to CY203, xa2 may be 0, and R₂₀₂ may be a group represented by one of Formulae CY204 to CY207.

In one or more embodiments, each of Formulae 201 and 202 may not include (e.g., may exclude) a group represented by one of Formulae CY201 to CY203.

In one or more embodiments, each of Formulae 201 and 202 may not include (e.g., may exclude) a group represented by one of Formulae CY201 to CY203, and may include at least one of the groups represented by Formulae CY204 to CY217.

In one or more embodiments, each of Formulae 201 and 202 may not include (e.g., may exclude) a group represented by one of Formulae CY201 to CY217.

For example, the hole transport region may include at least one of Compounds HT1 to HT50, m-MTDATA, TDATA, 2-TNATA, NPB(NPD), β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), CzSi(9-(4-tert-Butylphenyl)-3,6-bis(triphenylsilyl)-9H-carbazole), or one or more combinations thereof:

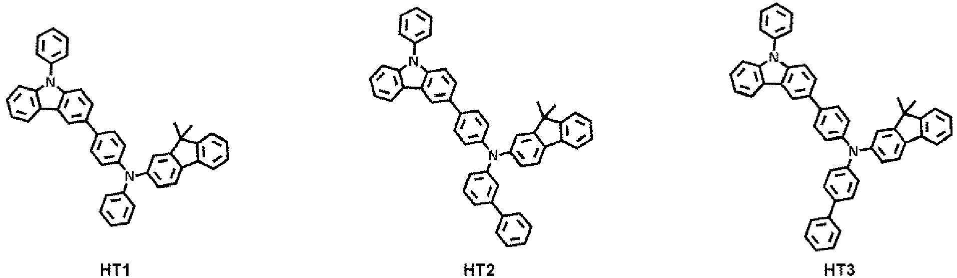

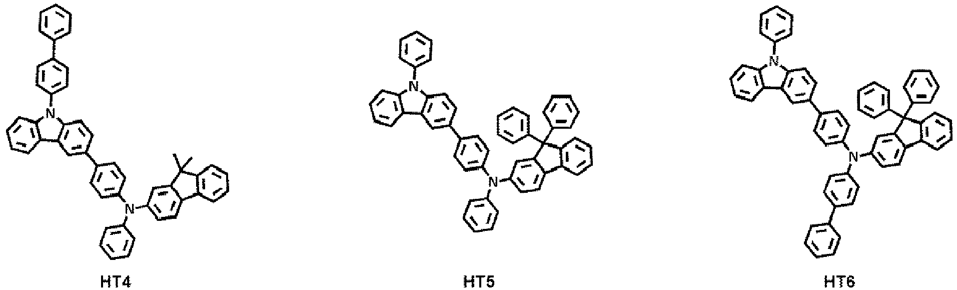

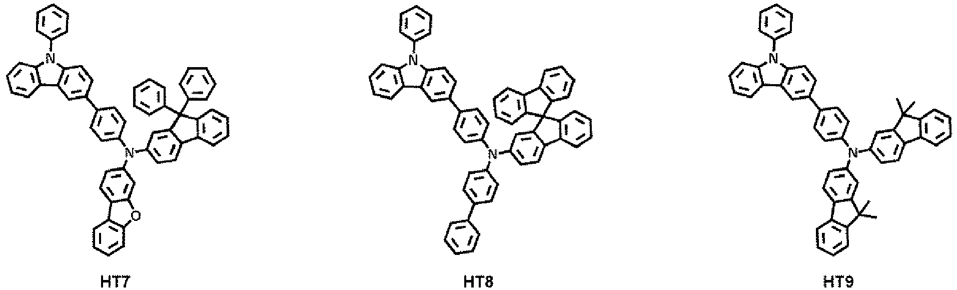

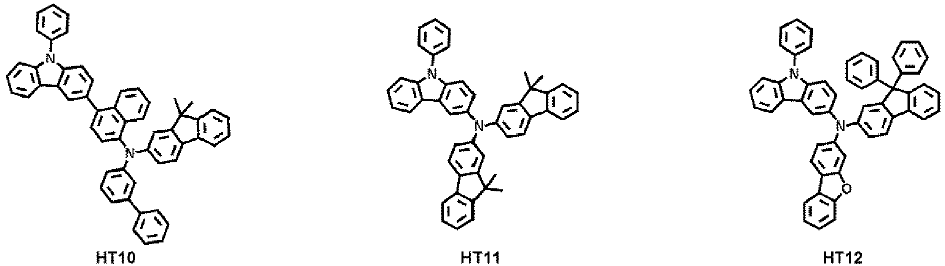

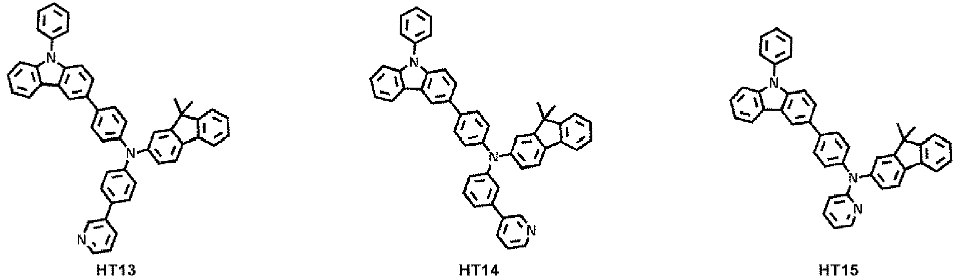

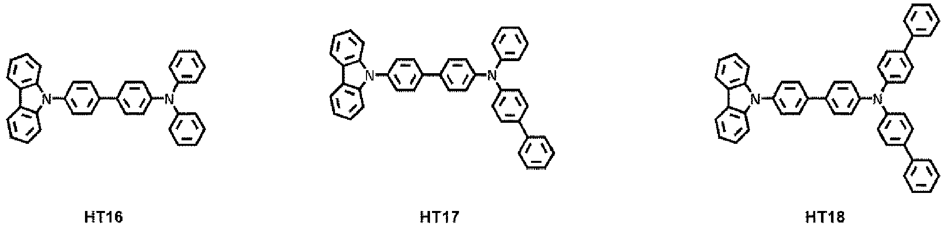

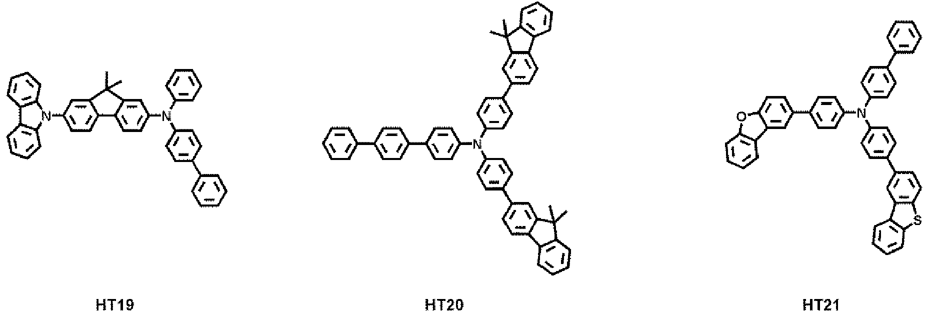

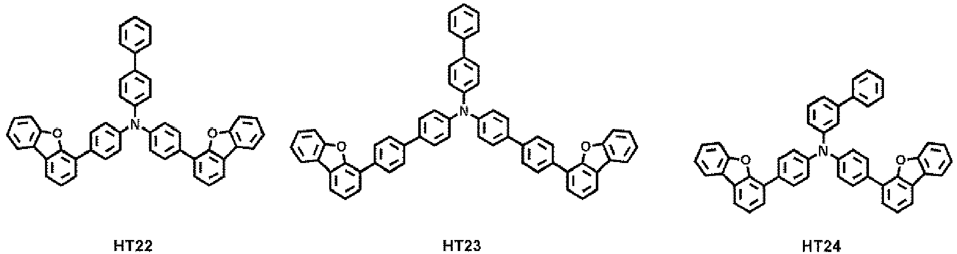

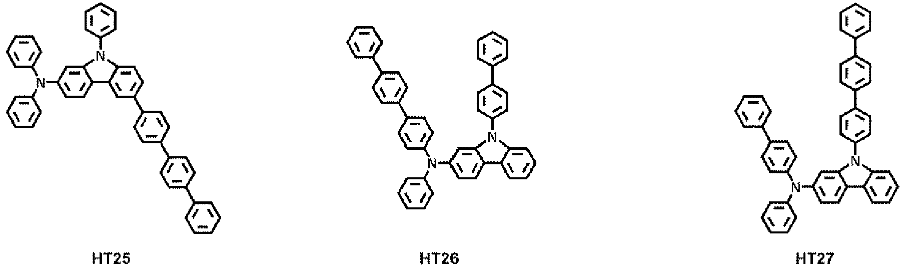

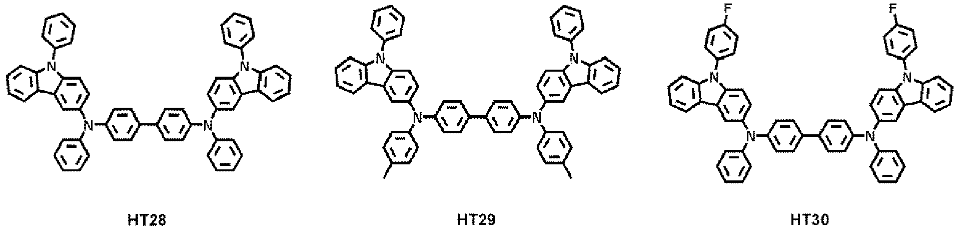

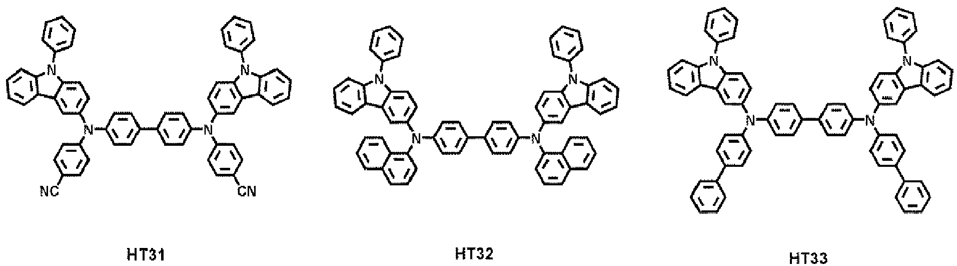

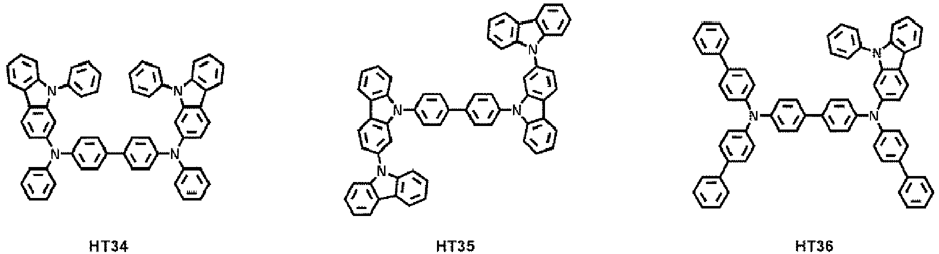

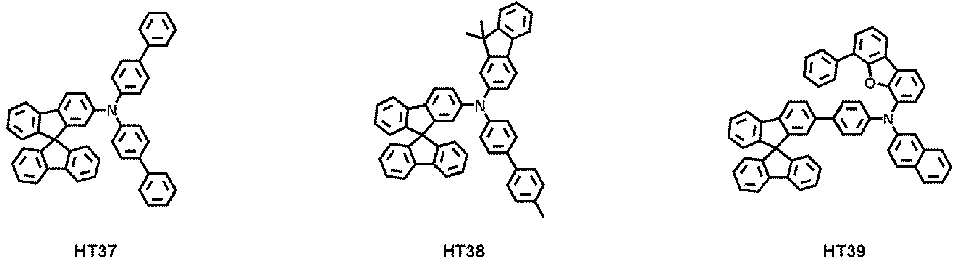

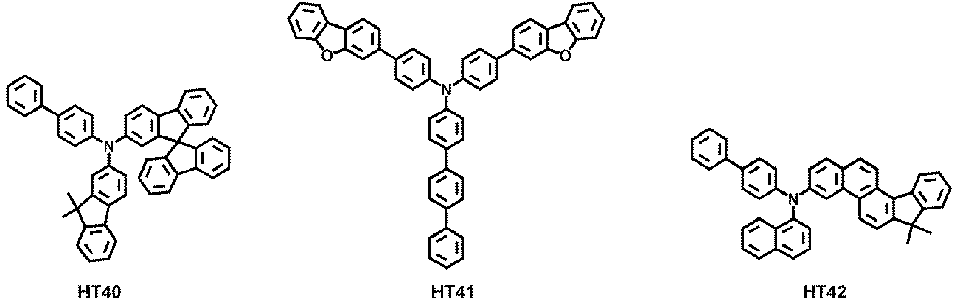

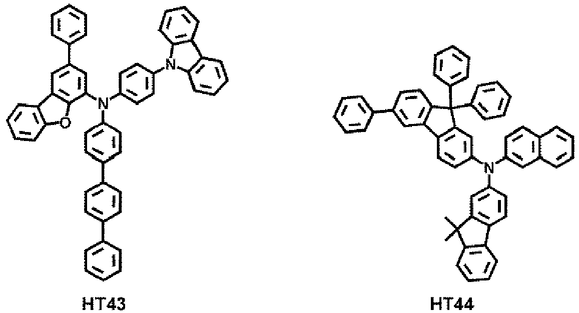

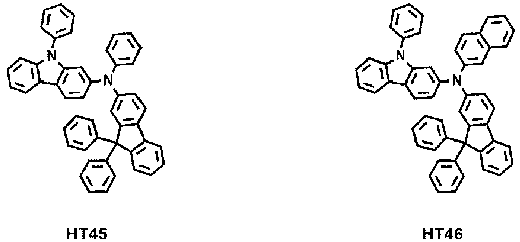

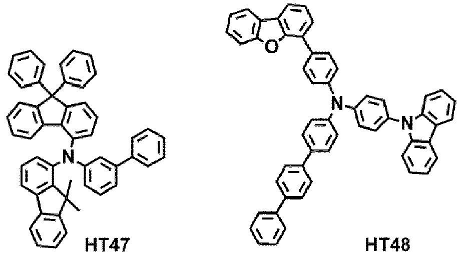

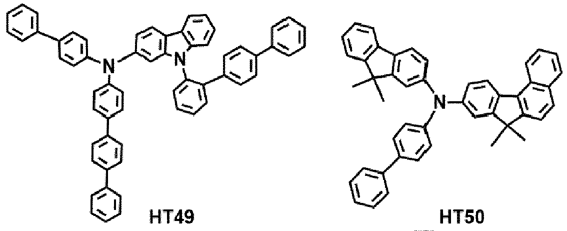

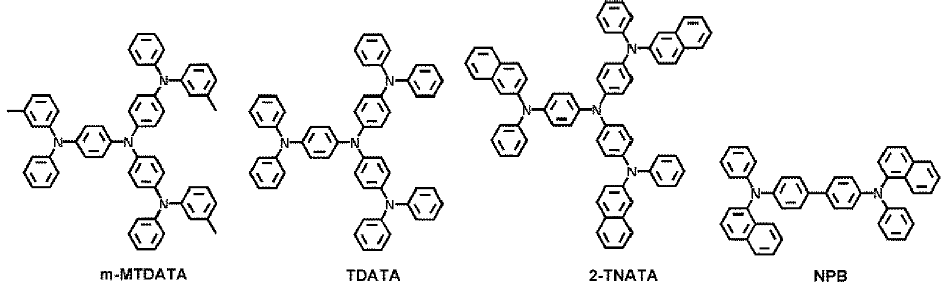

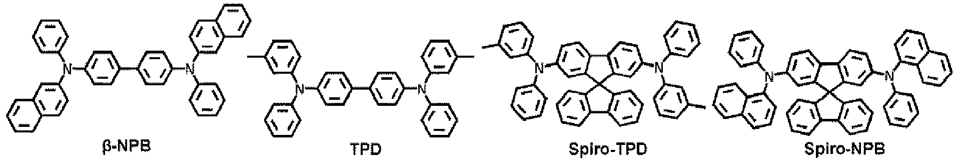

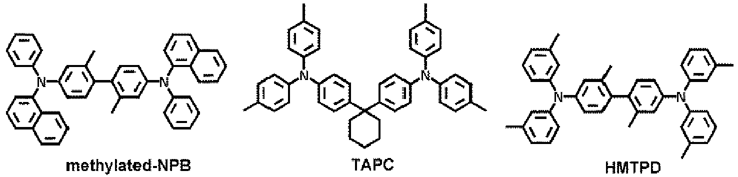

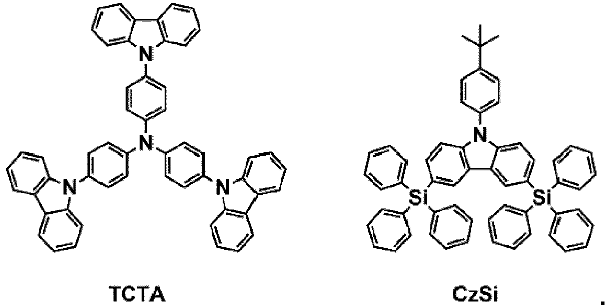

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, satisfactory (suitable) hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block or reduce the leakage of electrons from an emission layer to a hole transport region. Materials that may be included in the hole transport region may be included in the emission auxiliary layer and the electron blocking layer.

### p-dopant

The hole transport region may further include, in addition to these materials, a charge-generation material for the improvement of conductive properties. The charge-generation material may be substantially uniformly or non-uniformly dispersed in the hole transport region (for example, in the form of a single layer including (e.g., consisting of) a charge-generation material).

The charge-generation material may be, for example, a p-dopant.

For example, the lowest unoccupied molecular orbital (LUMO) energy level of the p-dopant may be -3.5 eV or less.

In one or more embodiments, the p-dopant may include a quinone derivative, a cyano group-containing compound, a compound including element EL1 and element EL2, or one or more combinations thereof.

Examples of the quinone derivative are TCNQ, F4-TCNQ, and/or the like.

Examples of the cyano group-containing compound are HAT-CN, a compound represented by Formula 221, and/or the like:

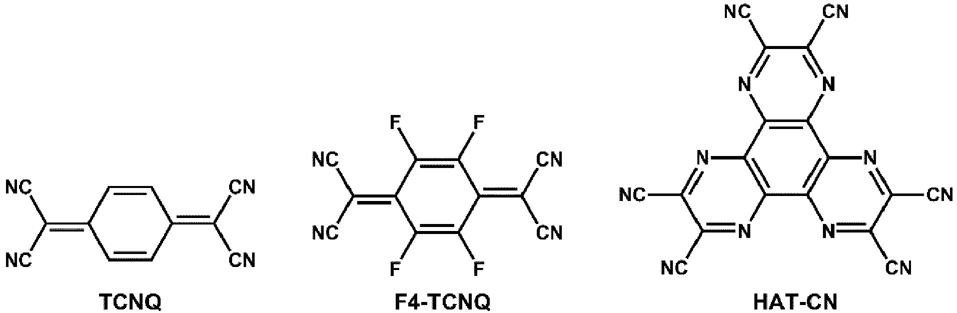

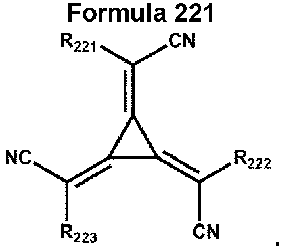

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or one or more combinations thereof.

In the compound including element EL1 and element EL2, element EL1 may be metal, metalloid, or any combination thereof, and element EL2 may be non-metal, metalloid, or any combination thereof.

Examples of the metal are an alkali metal (for example, lithium (Li), sodium (Na), potassium (K), rubidium (Rb), cesium (Cs), and/or the like); alkaline earth metal (for example, beryllium (Be), magnesium (Mg), calcium (Ca), strontium (Sr), barium (Ba), and/or the like); transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); post-transition metal (for example, zinc (Zn), indium (In), tin (Sn), and/or the like); and lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like).

Examples of the metalloid are silicon (Si), antimony (Sb), tellurium (Te), and/or the like.

Examples of the non-metal are oxygen (O) and halogen (for example, F, Cl, Br, I, and/or the like).

Examples of the compound including element EL1 and element EL2 are metal oxide, metal halide (for example, metal fluoride, metal chloride, metal bromide, or metal iodide), metalloid halide (for example, metalloid fluoride, metalloid chloride, metalloid bromide, or metalloid iodide), metal telluride, or one or more combinations thereof.

Examples of the metal oxide are tungsten oxide (for example, WO, W₂O₃, WO₂, WO₃, W₂O₅, and/or the like), vanadium oxide (for example, VO, V₂O₃, VO₂, V₂O₅, and/or the like), molybdenum oxide (MoO, Mo₂O₃, MoO₂, MoOs, Mo₂O₅, and/or the like), rhenium oxide (for example, ReOs and/or the like), and/or the like.

Examples of the metal halide are alkali metal halide, alkaline earth metal halide, transition metal halide, post-transition metal halide, lanthanide metal halide, and/or the like.

Examples of the alkali metal halide are LiF, NaF, KF, RbF, CsF, LiCl, NaCl, KOI, RbCl, CsCl, LiBr, NaBr, KBr, RbBr, CsBr, Lil, Nal, KI, Rbl, Csl, and/or the like.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and/or the like.

Examples of the transition metal halide are titanium halide (for example, TiF₄, TiCl₄, TiBr₄, TiI₄, and/or the like), zirconium halide (for example, ZrF₄, ZrCl₄, ZrBr₄, ZrI₄, and/or the like), hafnium halide (for example, HfF₄, HfCl₄, HfBr₄, HfI₄, and/or the like), vanadium halide (for example, VF₃, VCl₃, VBrs, VI₃, and/or the like), niobium halide (for example, NbFs, NbCl₃, NbBr₃, NbI₃, and/or the like), tantalum halide (for example, TaF₃, TaCl₃, TaBr₃, TaI₃, and/or the like), chromium halide (for example, CrFs, CrCl₃, CrBr₃, CrI₃, and/or the like), molybdenum halide (for example, MoF₃, MoCl₃, MoBr₃, MoI₃, and/or the like), tungsten halide (for example, WF₃, WCl₃, WBr₃, WI₃, and/or the like), manganese halide (for example, MnF₂, MnCl₂, MnBr₂, MnI₂, and/or the like), technetium halide (for example, TcF₂, TcCl₂, TcBr₂, TcI₂, and/or the like), rhenium halide (for example, ReF₂, ReCl₂, ReBr₂, ReI₂, and/or the like), ferroushalide (for example, FeF₂, FeCl₂, FeBr₂, FeI₂, and/or the like), ruthenium halide (for example, RuF₂, RuCl₂, RuBr₂, RuI₂, and/or the like), osmium halide (for example, OsF₂, OsCl₂, OsBr₂, OsI₂, and/or the like), cobalt halide (for example, CoF₂, CoCl₂, CoBr₂, CoI₂, and/or the like), rhodium halide (for example, RhF₂, RhCl₂, RhBr₂, RhI₂, and/or the like), iridium halide (for example, IrF₂, IrCl₂, IrBr₂, IrI₂, and/or the like), nickel halide (for example, NiF₂, NiCl₂, NiBr₂, NiI₂, and/or the like), palladium halide (for example, PdF₂, PdCl₂, PdBr₂, PdI₂, and/or the like), platinum halide (for example, PtF₂, PtCl₂, PtBr₂, PtI₂, and/or the like), cuproushalide (for example, CuF, CuCl, CuBr, Cul, and/or the like), silver halide (for example, AgF, AgCl, AgBr, Agl, and/or the like), gold halide (for example, AuF, AuCl, AuBr, Aul, and/or the like), and/or the like.

Examples of the post-transition metal halide are zinc halide (for example, ZnF₂, ZnCl₂, ZnBr₂, ZnI₂, and/or the like), indium halide (for example, InI₃ and/or the like), tin halide (for example, SnI₂ and/or the like), and/or the like.

Examples of the lanthanide metal halide are YbF, YbF₂, YbF₃, SmF₃, YbCl, YbCl₂, YbCl₃ SmCl₃, YbBr, YbBr₂, YbBr₃ SmBr₃, Ybl, YbI₂, YbI₃, SmI₃, and/or the like.

An example of the metalloid halide is antimony halide (for example, SbCl₅ and/or the like).

Examples of the metal telluride are alkali metal telluride (for example, Li₂Te, Na₂Te, K₂Te, Rb₂Te, Cs₂Te, and/or the like), alkaline earth metal telluride (for example, BeTe, MgTe, CaTe, SrTe, BaTe, and/or the like), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and/or the like), post-transition metal telluride (for example, ZnTe and/or the like), and lanthanide metal telluride (for example, LaTe, CeTe, PrTe, NdTe, PmTe, EuTe, GdTe, TbTe, DyTe, HoTe, ErTe, TmTe, YbTe, LuTe, and/or the like).

### Emission layer in interlayer 130

When the light-emitting device 10 is a full-color light-emitting device, the emission layer may be patterned into a red emission layer, a green emission layer, and/or a blue emission layer, according to a sub-pixel. In an embodiment, the emission layer may have a stacked structure of two or more layers of a red emission layer, a green emission layer, and a blue emission layer, in which the two or more layers contact each other or are separated from each other to emit white light. In one or more embodiments, the emission layer may include two or more materials of a red light-emitting material, a green light-emitting material, and a blue light-emitting material, in which the two or more materials are mixed with each other in a single layer to emit white light. For example, the emission layer may emit blue light.

For example, the blue light may have a wavelength in a range of about 400 nm to about 490 nm. For example, the blue light may have a wavelength in a range of about 440 nm to about 470 nm.

In an embodiment, the emission layer may include the first emission layer and the second emission layer, the first emission layer may include the first host, and the second emission layer may include the second host. The first host may include the first-first host and the first-second host, and the second host may include the second-first host and the second-second host.

The dopant may include the compound represented by Formula 3.

The phosphorescent dopant or the fluorescent dopant that may be included in the emission layer may be understood by referring to the descriptions of the phosphorescent dopant or the fluorescent dopant provided herein.

In one or more embodiments, the emission layer may include a quantum dot.

In one or more embodiments, the emission layer may include a delayed fluorescence material. The delayed fluorescence material may act as a host or a dopant in the emission layer.

A thickness of the emission layer may be in a range of about 100 Å to about 1,000 Å, for example, about 200 Å to about 600 Å. When the thickness of the emission layer is within these ranges, excellent or suitable luminescence characteristics may be obtained without a substantial increase in driving voltage.

### Host

In an embodiment, the first host and the second host may each independently further include a carbazole-containing compound, an anthracenecontaining compound, a triazine-containing compound, or one or more combinations thereof. In one or more embodiments, the first host and the second may each independently further include, for example, a carbazole-containing compound and/or a triazine-containing compound.

In one or more embodiments, the first host and the second host may each independently further include a compound represented by Formula 301:

**Formula 301** **[Ar₃₀₁]_{xb11}-[(L₃₀₁)_{xb1}-R₃₀₁]_{xb21}**

wherein, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ may respectively be the same as described in connection with Q₁.

For example, when xb11 in Formula 301 is 2 or more, two or more of Ar₃₀₁ may be linked to each other via a single bond.

In one or more embodiments, the first host and the second host may each independently further include a compound represented by Formula 301-1, a compound represented by Formula 301-2, or any combination thereof:

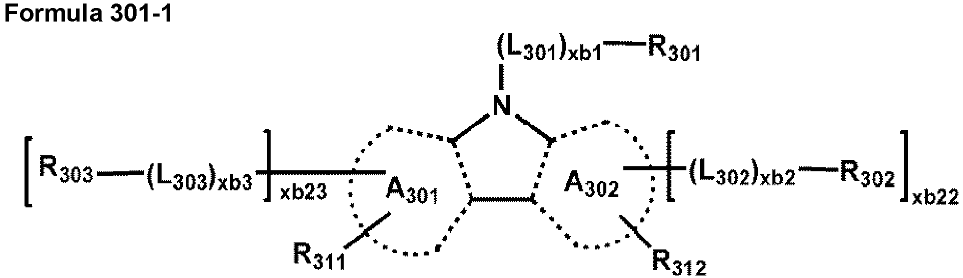

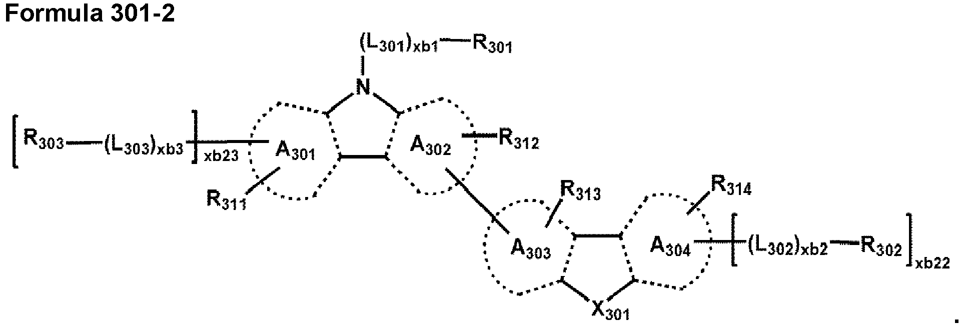

In Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described herein,
L₃₀₂ to L₃₀₄ may each independently be the same as described in connection with L₃₀₁,
xb2 to xb4 may each independently be the same as described in connection with xb1, and
R₃₀₂ to R₃₀₅ and R₃₁₁ to R₃₁₄ may each be the same as described in connection with R₃₀₁.

In one or more embodiments, the first host and the second host may each independently further include an alkaline earth metal complex, a post-transition metal complex, or any combination thereof. For example, the first host and the second host may each independently further include a Be complex (for example, Compound H55), a Mg complex, a Zn complex, or one or more combinations thereof.

In one or more embodiments, the first host and the second host may each independently further include at least one of Compounds H1 to H131, 9,10-di(2-naphthyl)anthracene (DNA), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-(9-carbazolyl)benzene (mCP), 1,3,5-tri(carbazol-9-yl)benzene (TCP), or one or more combinations thereof:

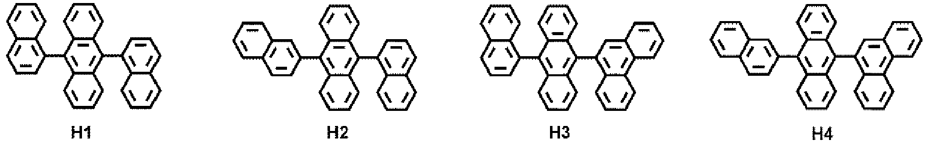

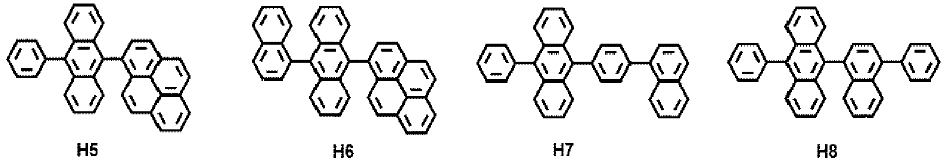

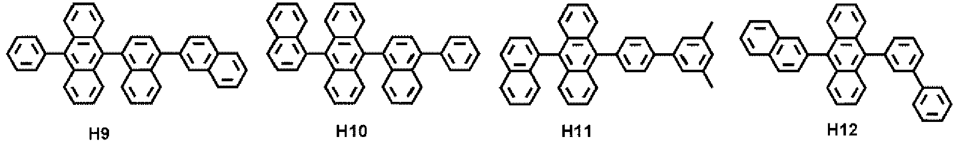

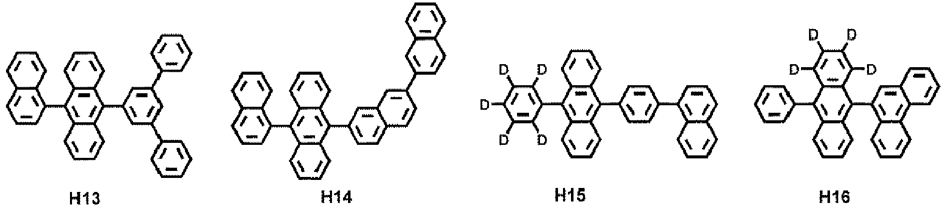

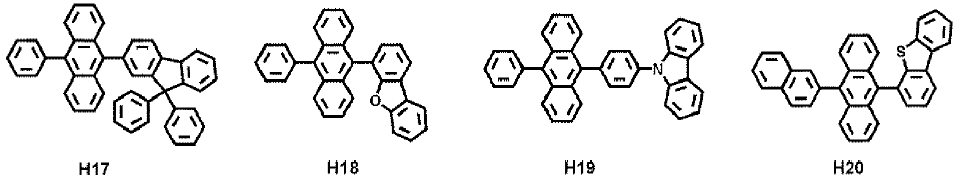

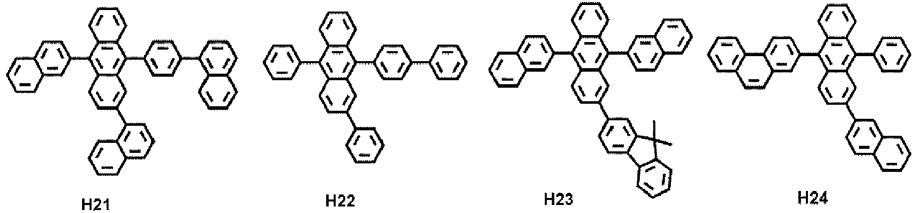

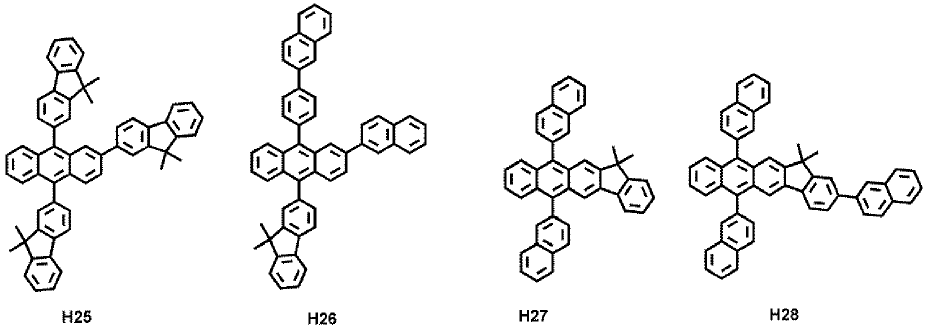

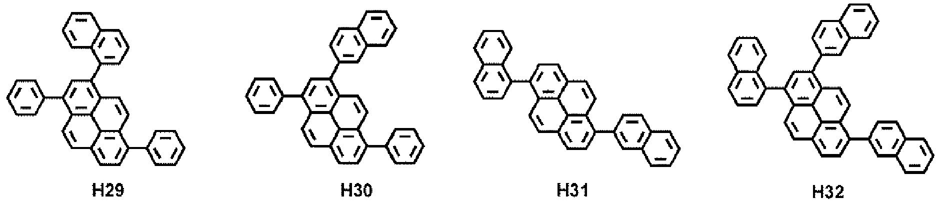

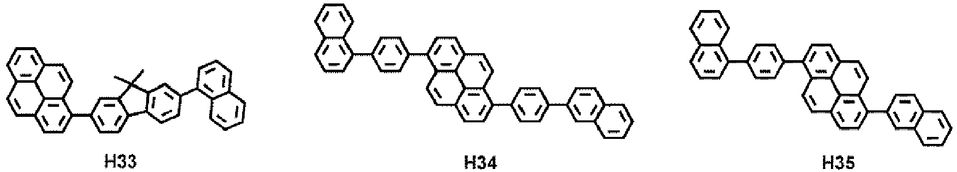

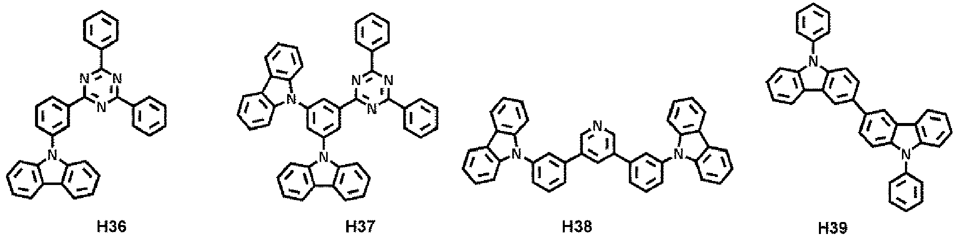

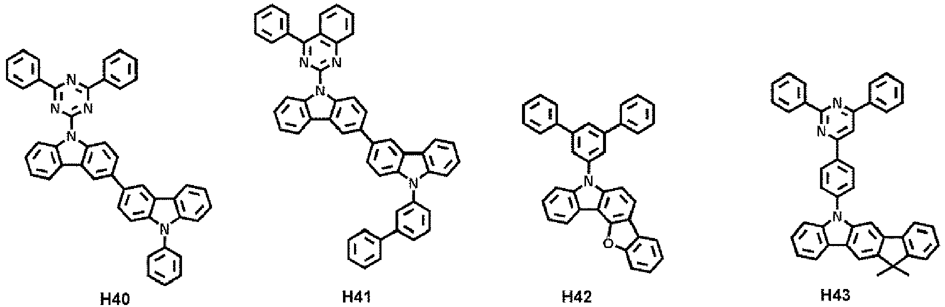

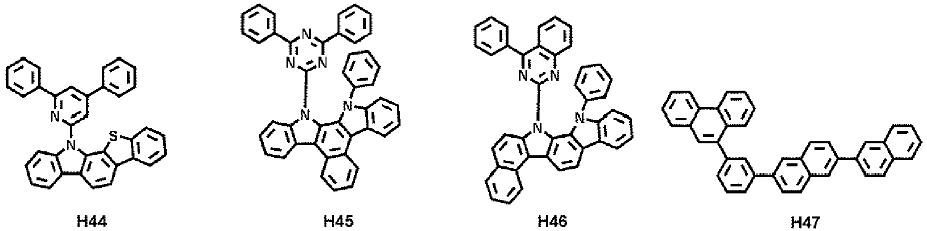

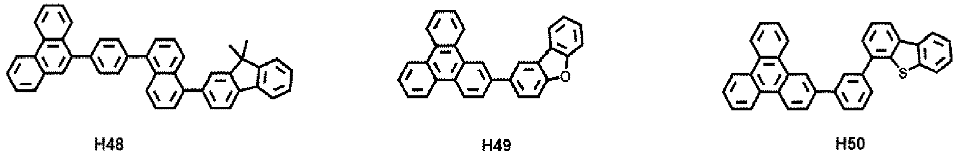

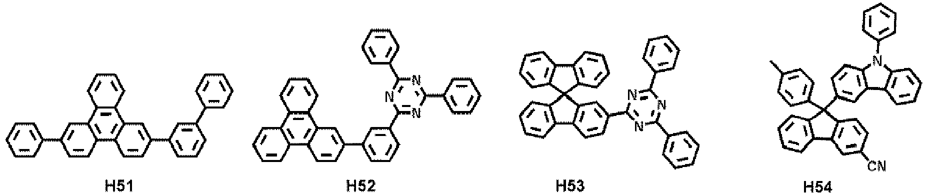

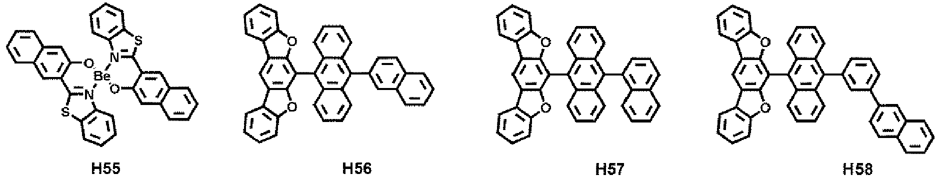

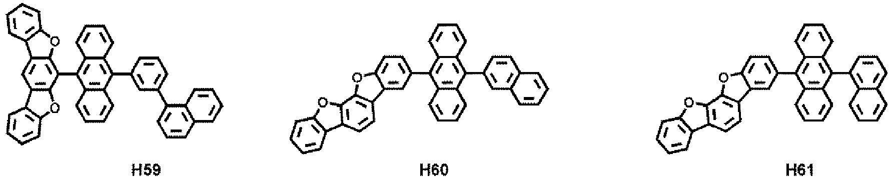

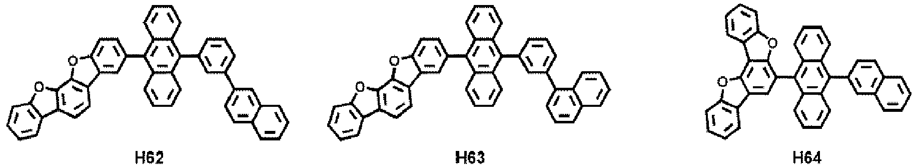

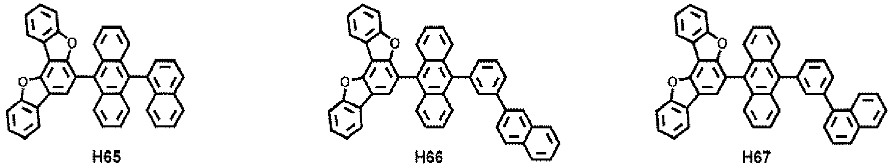

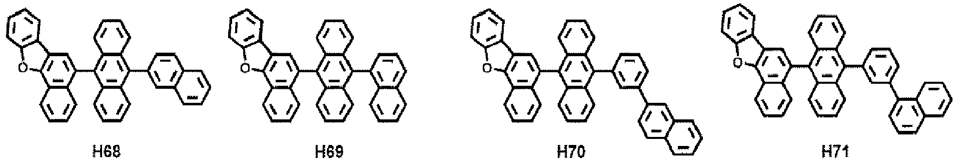

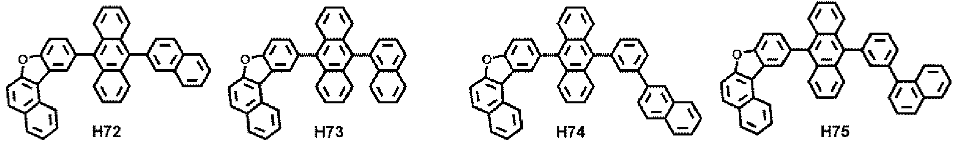

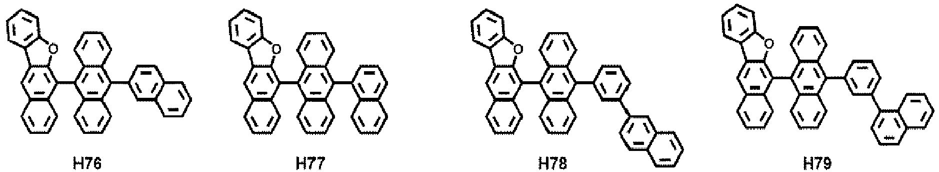

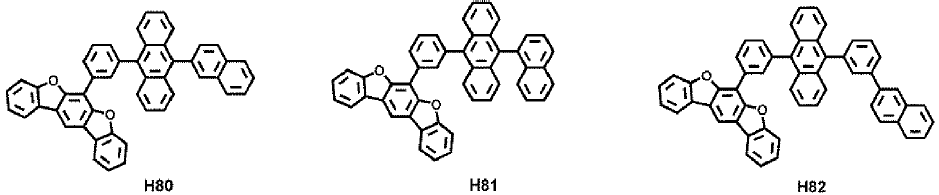

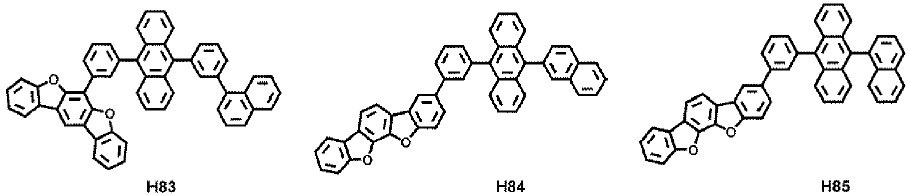

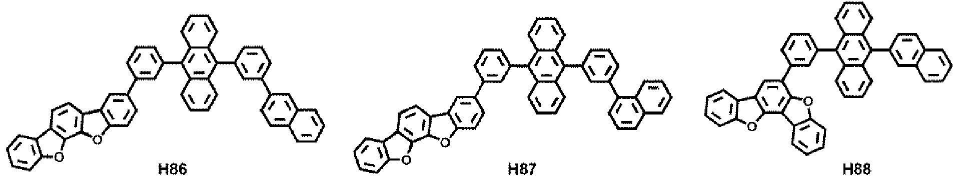

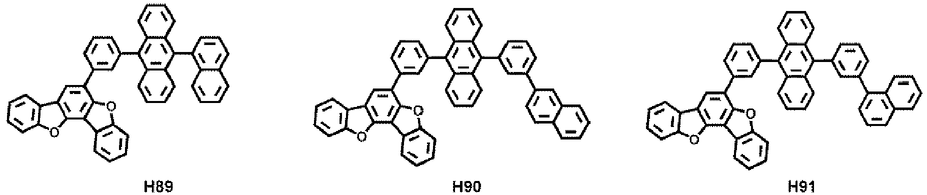

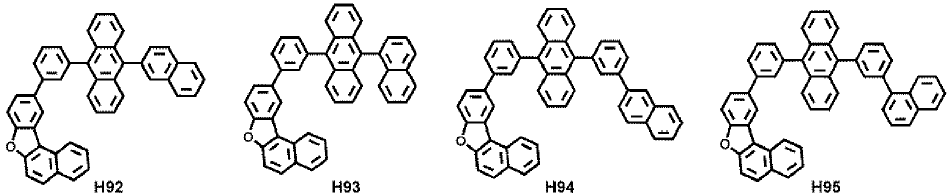

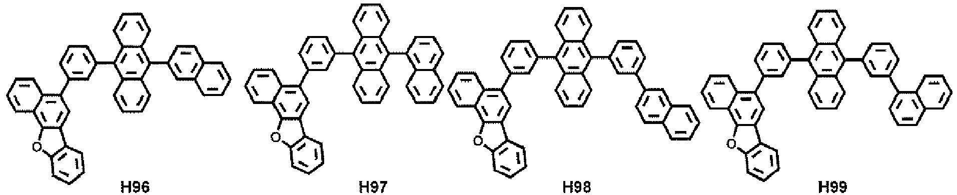

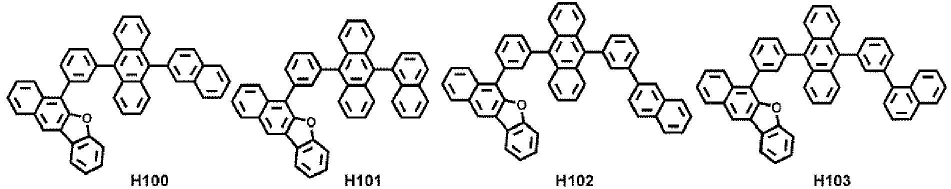

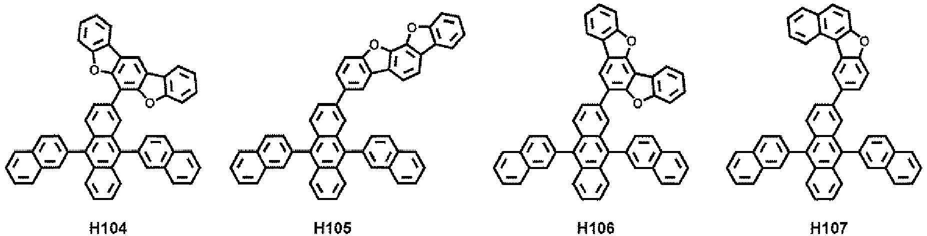

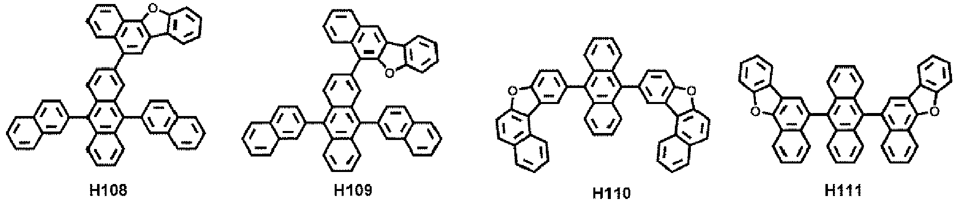

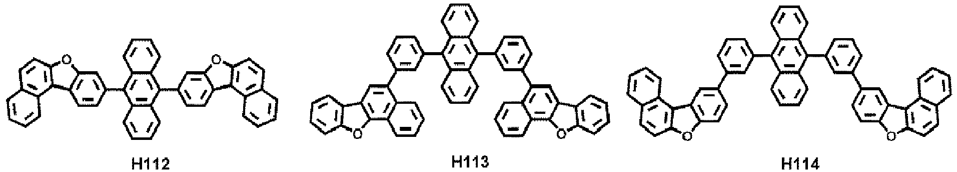

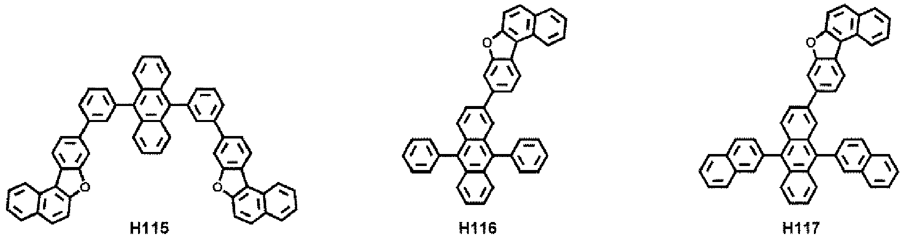

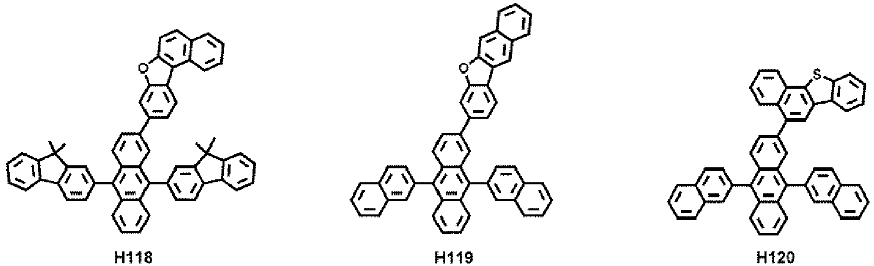

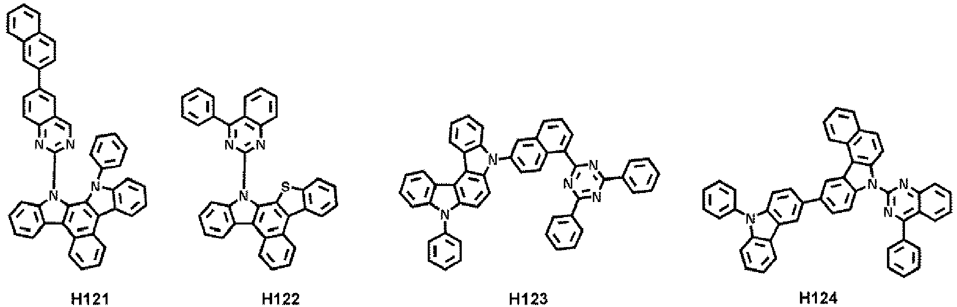

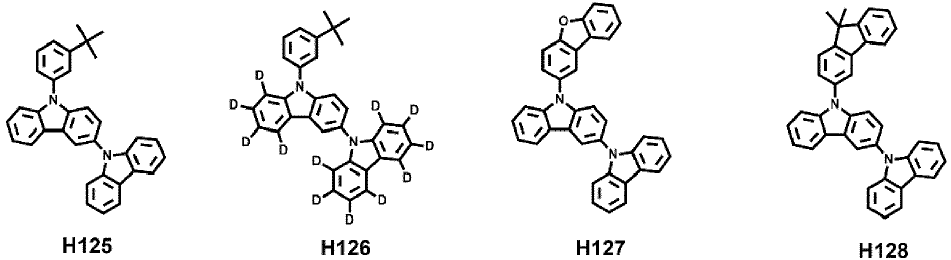

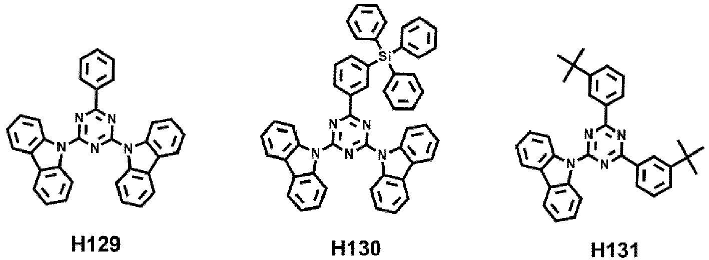

### Phosphorescent dopant

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or one or more combinations thereof.

The phosphorescent dopant may be electrically neutral.

For example, the phosphorescent dopant may include an organometallic compound represented by Formula 401:

**Formula 401** **M(L₄₀₁)_{xc1}(L₄₀₂)_{xc2}**

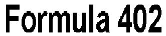

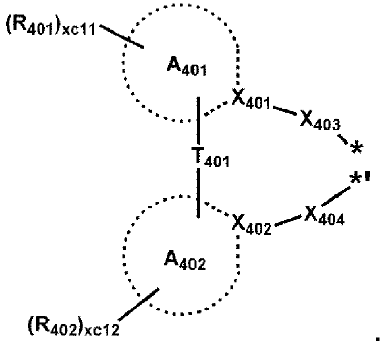

In Formulae 401 and 402,
M may be a transition metal (for example, Ir, Pt, Pd, Os, Ti, Au, Hf, Eu, Tb, Rh, Re, or Tm),
L₄₀₁ may be a ligand represented by Formula 402, and xc1 may be 1, 2, or 3, wherein, when xc1 is two or more, two or more of L₄₀₁ may be identical to or different from each other,
L₄₀₂ may be an organic ligand, and xc2 may be 0, 1, 2, 3, or 4, wherein, when xc2 is 2 or more, two or more of L₄₀₂ may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordination bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each respectively be the same as described in connection with Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), or -P(=O)(Q₄₀₁)(Q₄₀₂),
Q₄₀₁ to Q₄₀₃ may respectively be the same as described in connection with Q1,
xc11 and xc12 may each independently be an integer from 0 to 10, and
* and *' in Formula 402 each indicate a binding site to M in Formula 401.

For example, in Formula 402, i) X₄₀₁ may be nitrogen and X₄₀₂ may be carbon, or ii) each of X₄₀₁ and X₄₀₂ may be nitrogen.

In an embodiment, when xc1 in Formula 401 is 2 or more, two ring A₄₀₁(s) among two or more of L₄₀₁(s) may be optionally linked to each other via T₄₀₂, which is a linking group, and two ring A₄₀₂(s) among two or more of L₄₀₁(s) may be optionally linked to each other via T₄₀₃, which is a linking group (see Compounds PD1 to PD4 and PD7). T₄₀₂ and T₄₀₃ may respectively be the same as described in connection with T₄₀₁.

In Formula 401, L₄₀₂ may be an organic ligand. For example, L₄₀₂ may include a halogen group, a diketone group (for example, an acetylacetonate group), a carboxylic acid group (for example, a picolinate group), -C(=O) group, an isonitrile group, a -CN group, a phosphorus containing group (for example, a phosphine group, a phosphite group, and/or the like), or one or more combinations thereof.

The phosphorescent dopant may include, for example, at least one Compounds PD1 to PD39, PS-1, PS-2, or one or more combinations thereof:

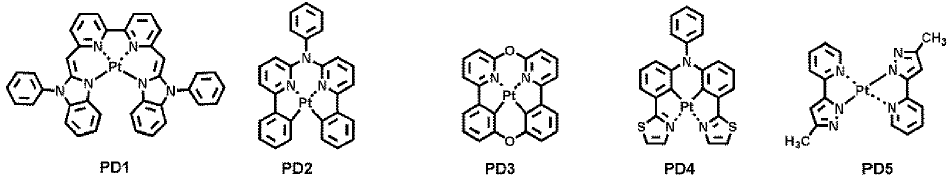

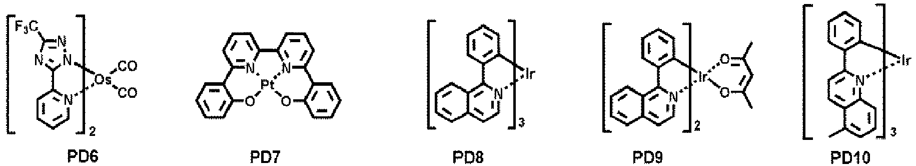

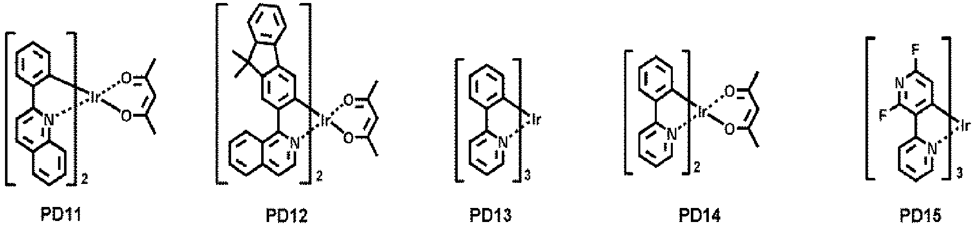

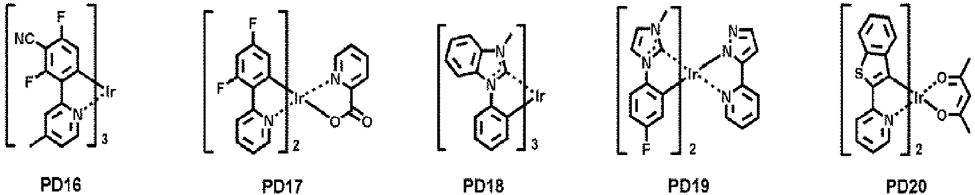

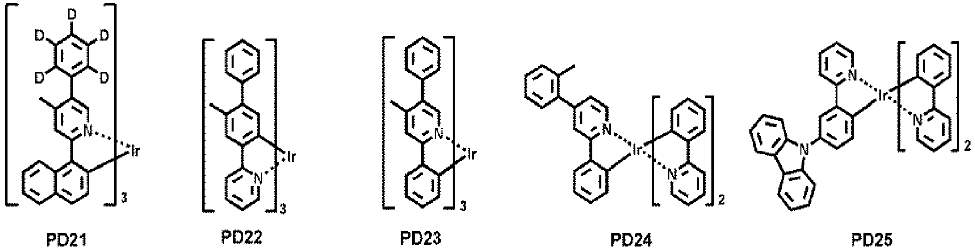

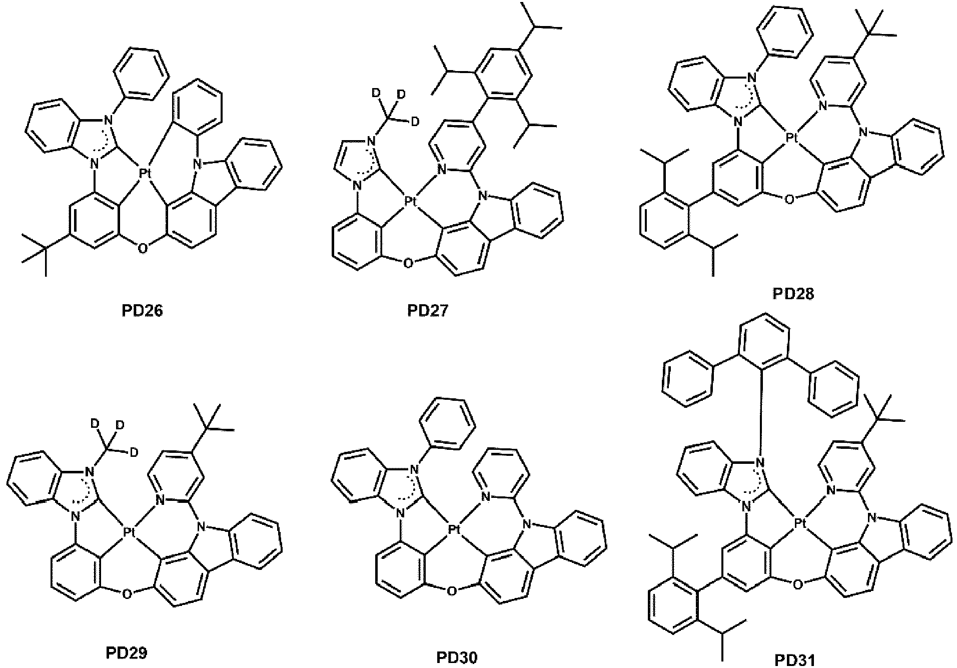

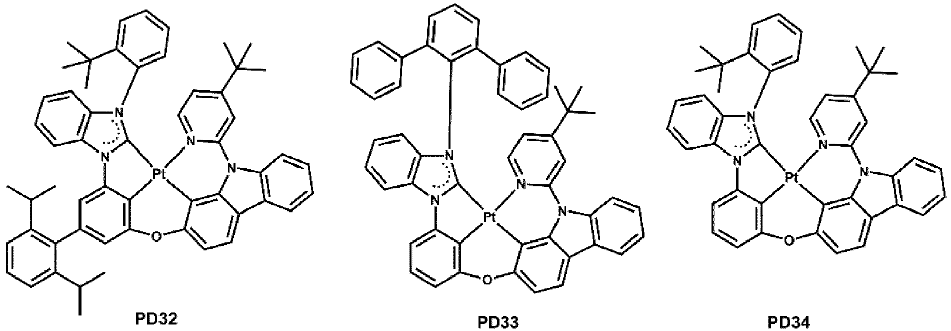

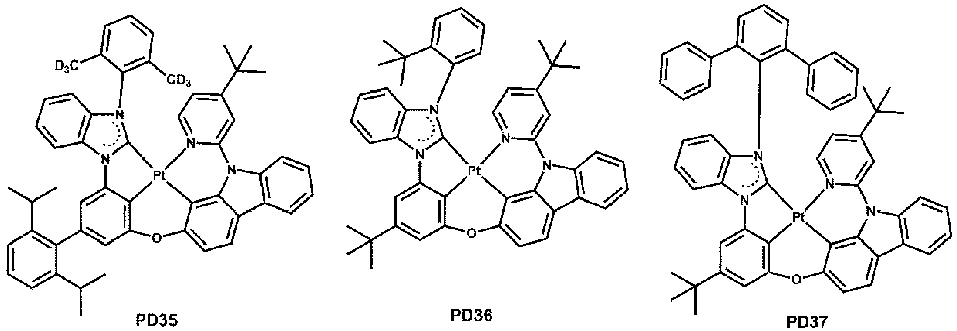

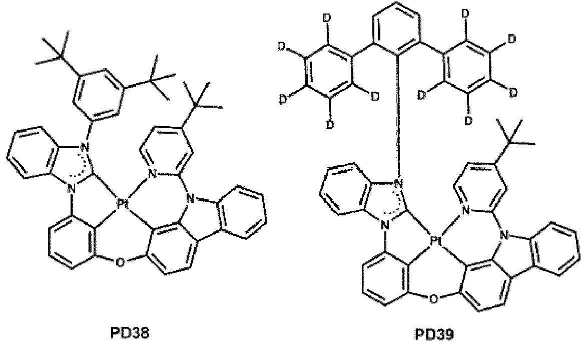

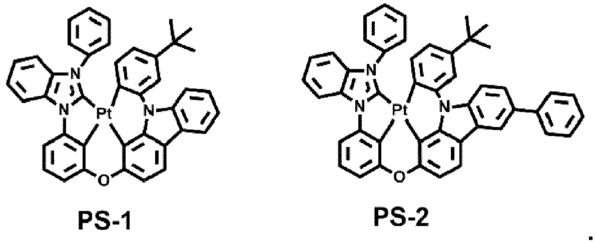

### Fluorescent dopant

The fluorescent dopant may include an amine group-containing compound, a styryl group-containing compound, or any combination thereof.

For example, the fluorescent dopant may include a compound represented by Formula 501:

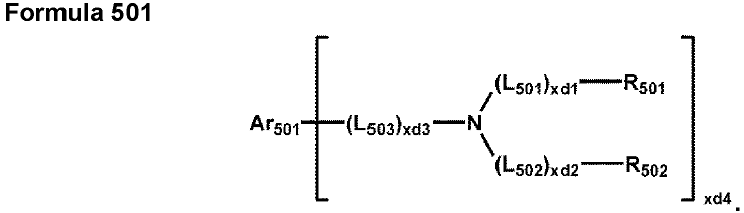

In Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (for example, an anthracene group, a chrysene group, or a pyrene group) in which three or more monocyclic groups are condensed together.

In an embodiment, xd4 in Formula 501 may be 2.

For example, the fluorescent dopant may include: at least one of Compounds FD1 to FD36; DPVBi; DPAVBi; or one or more combinations thereof:

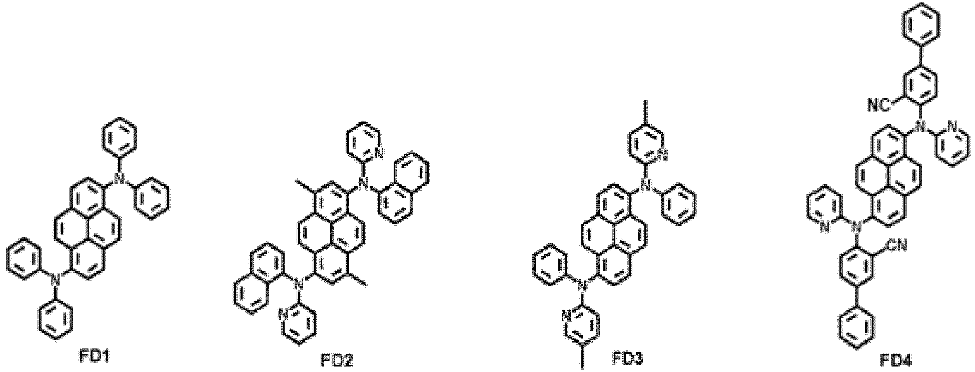

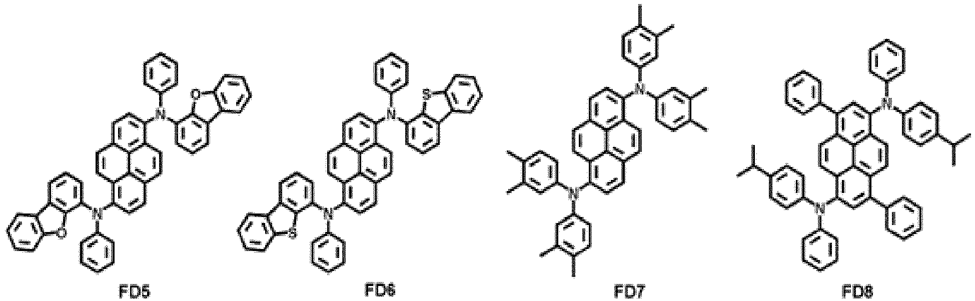

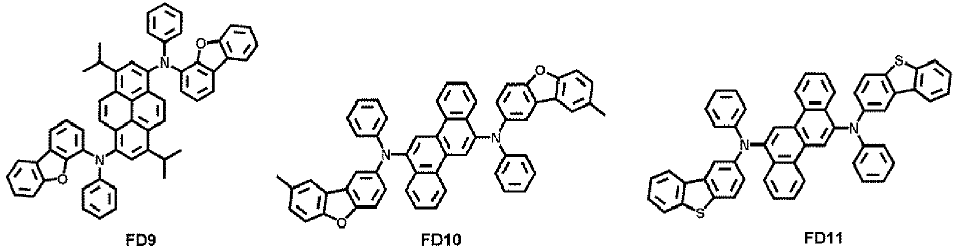

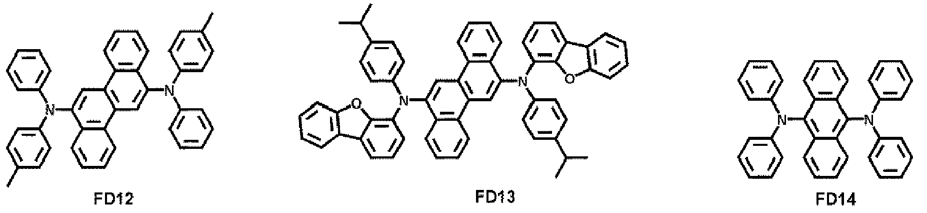

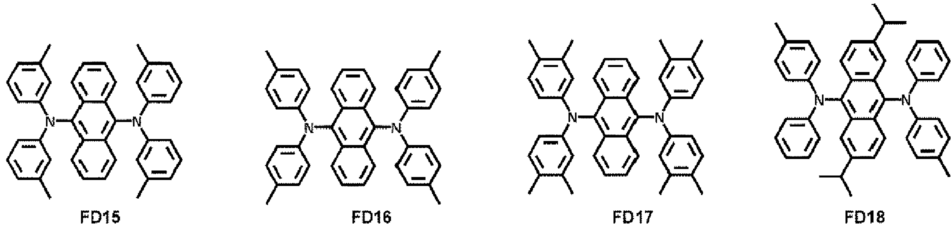

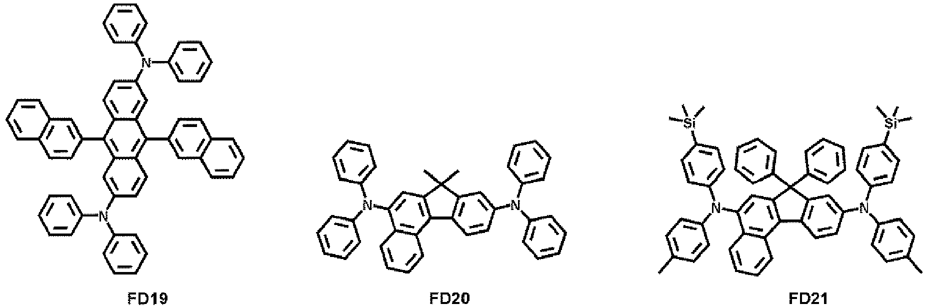

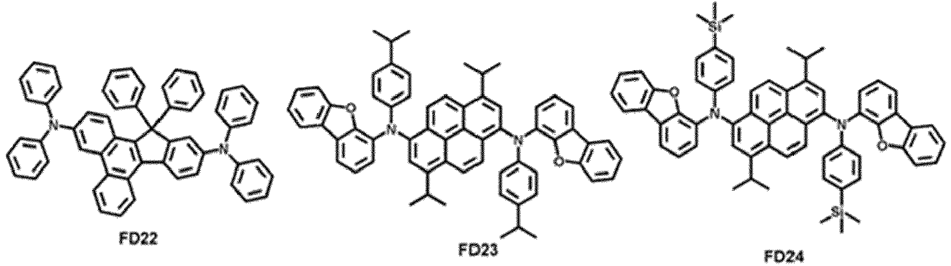

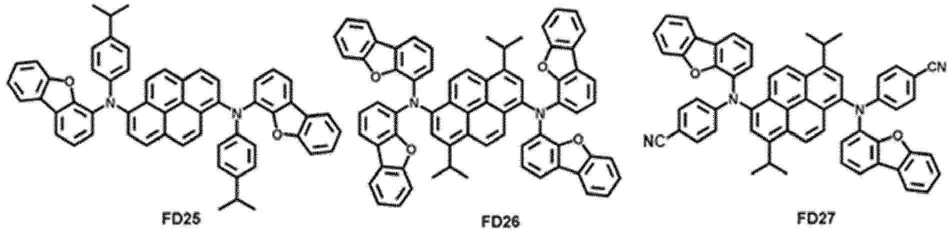

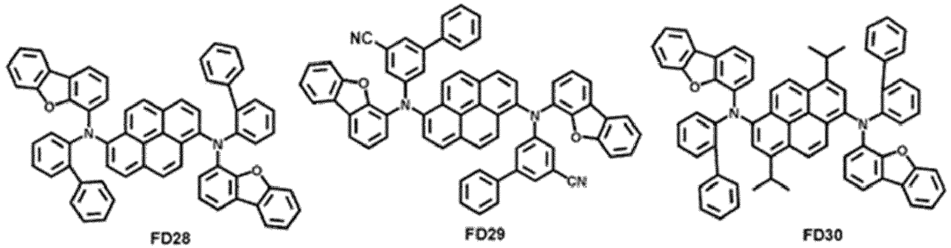

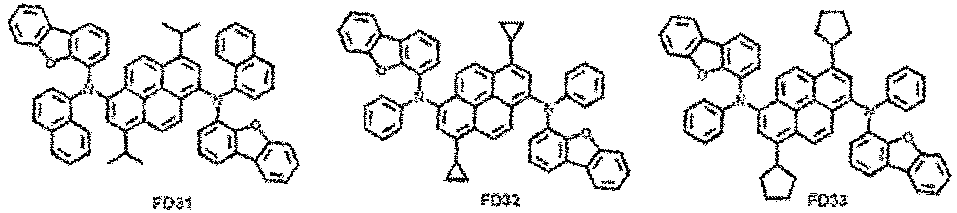

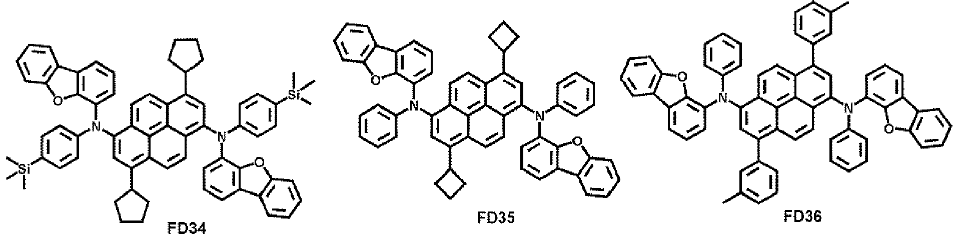

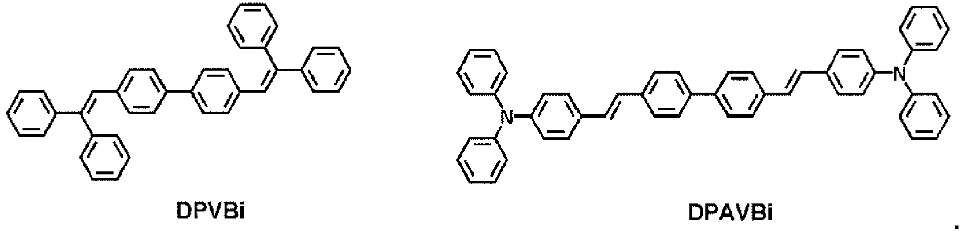

### Delayed fluorescence material

The emission layer may further include a delayed fluorescence material. The second emission layer may further include a delayed fluorescence material.

In the present specification, the delayed fluorescence material may be selected from compounds capable of emitting delayed fluorescent light based on a delayed fluorescence emission mechanism.

The delayed fluorescence material, which is further included in the emission layer, may act as a host or a dopant depending on the type or kind of other materials included in the emission layer. The delayed fluorescence material further included in the second emission layer may act as a host or a dopant, depending on the type or kind of other materials included in the second emission layer.

In an embodiment, a difference between a triplet energy level (eV) of the delayed fluorescence material and a singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material is satisfied within the range above, up-conversion from the triplet state to the singlet state of the delayed fluorescence materials may effectively occur, thereby improving (increasing) luminescence efficiency of the light-emitting device 10.

For example, the delayed fluorescence material may include i) a material including at least one electron donor (for example, a π electron-rich C₃-C₆₀ cyclic group, such as a carbazole group) and at least one electron acceptor (for example, a sulfoxide group, a cyano group, or a π electron-deficient nitrogen-containing C₁-C₆₀ cyclic group), and ii) a material including a C₈-C₆₀ polycyclic group in which two or more cyclic groups are condensed while sharing boron atom (B).

The delayed fluorescence material may include, for example, at least one of Compounds DF1 to DF9:

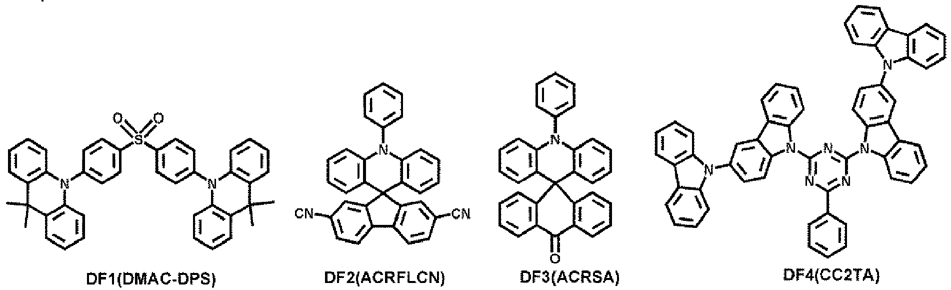

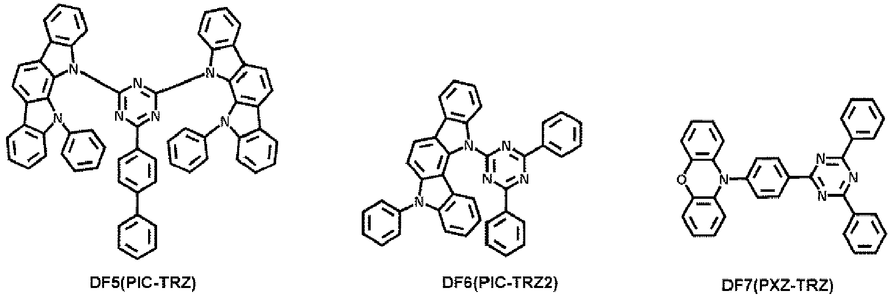

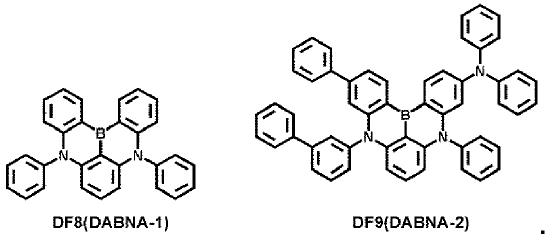

### Quantum dot

The emission layer may include a quantum dot. The second emission layer may include a quantum dot.

The term "quantum dot" as utilized herein refers to a crystal of a semiconductor compound, and may include any suitable material capable of emitting light of one or more suitable emission wavelengths according to the size of the crystal.

A diameter of the quantum dot (e.g., an average diameter of quantum dots) may be, for example, in a range of about 1 nm to about 10 nm.

The quantum dot may be synthesized by a wet chemical process, a metal organic chemical vapor deposition (MOCVD) process, a molecular beam epitaxy (MBE) process, or any process similar thereto.

The wet chemical process is a method including mixing a precursor material with an organic solvent and then growing a quantum dot particle crystal. When the crystal grows, the organic solvent naturally acts as a dispersant coordinated on the surface of the quantum dot crystal and controls the growth of the crystal so that the growth of quantum dot particles can be controlled or selected through a process which costs less, and is easier than vapor deposition methods, such as metal organic chemical vapor deposition process or molecular beam epitaxy process.

The quantum dot may include a Group II-VI semiconductor compound, a Group III-V semiconductor compound, a Group III-VI semiconductor compound, a Group I-III-VI semiconductor compound, a Group IV-VI semiconductor compound, a Group IV element or compound, or one or more combinations thereof.

Examples of the Group II-VI semiconductor compound are: a binary compound, such as CdSe, CdTe, ZnS, ZnSe, ZnTe, ZnO, HgS, HgSe, HgTe, MgSe, or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound, such as CdZnSeS, CdZnSeTe, CdZnSTe, CdHgSeS, CdHgSeTe, CdHgSTe, HgZnSeS, HgZnSeTe, or HgZnSTe; and/or one or more combinations thereof.

Examples of the Group III-V semiconductor compound are: a binary compound such as GaN, GaP, GaAs, GaSb, AlN, AlP, AlAs, AlSb, InN, InP, InAs, or InSb; a ternary compound such as GaNP, GaNAs, GaNSb, GaPAs, GaPSb, AlNP, AlNAs, AlNSb, AlPAs, AlPSb, InGaP, InNP, InAIP, InNAs, InNSb, InPAs, or InPSb; a quaternary compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, or InAlPSb; and/or one or more combinations thereof. In some embodiments, the Group III-V semiconductor compound may further include a Group II element. Examples of the Group III-V semiconductor compound further including a Group II element are InZnP, InGaZnP, InAlZnP, and/or the like

Examples of the Group III-VI semiconductor compound are: a binary compound, such as GaS, GaSe, Ga₂Se₃, GaTe, InS, InSe, In₂S₃, In₂Se₃, or InTe; a ternary compound, such as InGaS₃, or InGaSe₃; and/or one or more combinations thereof.

Examples of the Group I-III-VI semiconductor compound are: a ternary compound, such as AgInS, AgInS₂, CuInS, CuInS₂, CuGaO₂, AgGaO₂, or AgAlO₂; and/or one or more combinations thereof.

Examples of the Group IV-VI semiconductor compound are: a binary compound, such as SnS, SnSe, SnTe, PbS, PbSe, or PbTe; a ternary compound, such as SnSeS, SnSeTe, SnSTe, PbSeS, PbSeTe, PbSTe, SnPbS, SnPbSe, or SnPbTe; a quaternary compound, such as SnPbSSe, SnPbSeTe, or SnPbSTe; and/or one or more combinations thereof.

The Group IV element or compound are: a single element compound, such as Si or Ge; a binary compound, such as SiC or SiGe; or one or more combinations thereof.

Each element included in a multi-element compound such as the binary compound, the ternary compound, and/or the quaternary compound may be present at a substantially uniform concentration or non-uniform concentration in a particle.

In some embodiments, the quantum dot may have a single structure in which the concentration of each element in the quantum dot is substantially uniform, or a core-shell dual structure. For example, the material included in the core and the material included in the shell may be different from each other.

The shell of the quantum dot may act as a protective layer that prevents chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases toward the center of the core.

Examples of the shell of the quantum dot may be an oxide of metal, metalloid, or non-metal, a semiconductor compound, and/or one or more combinations thereof. Examples of the oxide of metal, metalloid, or non-metal are a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound, such as MgAl₂O₄, CoFe₂O₄, NiFe₂O₄, or CoMn₂O₄; and/or one or more combinations thereof. Examples of the semiconductor compound are, as described herein, a Group II-VI semiconductor compound; a Group III-V semiconductor compound; a Group III-VI semiconductor compound; a Group I-III-VI semiconductor compound; a Group IV-VI semiconductor compound; and/or one or more combinations thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or one or more combinations thereof.

A full width at half maximum (FWHM) of the emission wavelength spectrum of the quantum dot may be about 45 nm or less, for example, about 40 nm or less, for example, about 30 nm or less, and within these ranges, color purity or color reproducibility may be increased. In some embodiments, because the light emitted through the quantum dot is emitted in all directions, the wide viewing angle may be improved (increased).

In some embodiments, the quantum dot may be in the form of a substantially spherical particle, a pyramidal particle, a multi-arm particle, a cubic nanoparticle, a nanotube particle, a nanowire particle, a nanofiber particle, or a nanoplate particle.

Because the energy band gap may be adjusted by controlling (selecting) the size of the quantum dot, light having one or more suitable wavelength bands may be obtained from the quantum dot emission layer. Accordingly, by utilizing quantum dots of different sizes, a light-emitting device that emits light of one or more suitable wavelengths may be implemented. In some embodiments, the size of the quantum dot may be selected to emit red, green, and/or blue light. In some embodiments, the size of the quantum dots may be configured to emit white light by a combination of light of one or more suitable colors.

### Electron transport region in interlayer 130

The electron transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron transport region may include a buffer layer, a hole blocking layer, an electron transport layer, an electron control layer, an electron injection layer, or one or more combinations thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein the layers of each structure are stacked sequentially from the emission layer.

The electron transport region (for example, the buffer layer, the hole blocking layer, the electron control layer, or the electron transport layer in the electron transport region) may further include a metal-free compound including at least one π electron-deficient nitrogen-containing C₁-C₆₀ cyclic group.

For example, the electron transport region may further include a compound represented by Formula 601:

**Formula 601** **[Ar₆₀₁]ₓₑ₁₁-[(L₆₀₁)ₓₑ₁-R₆₀₁]ₓₑ₂₁**

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group unsubstituted or substituted with at least one R₁₀ₐ.

For example, when xe11 in Formula 601 is 2 or more, two or more of Ar₆₀₁ may be linked to each other via a single bond.

In an embodiment, Ar₆₀₁ in Formula 601 may be a substituted or unsubstituted anthracene group.

In one or more embodiments, the electron transport region may further include a compound represented by Formula 601-1: 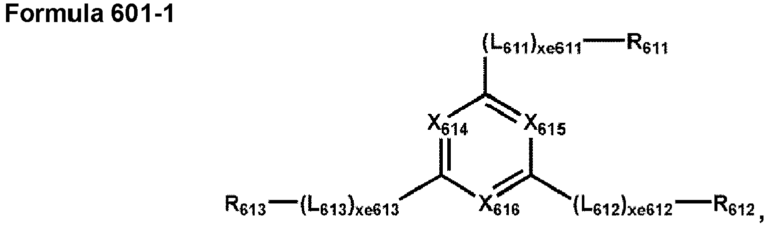 wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each be the same as described in connection with L₆₀₁,
xe611 to xe613 may each be the same as described in connection with xe1,
R₆₁₁ to R₆₁₃ may each be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

The electron transport region may include at least one of Compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, TSPO1, TPBI, DBFTRZ, or one or more combinations thereof:

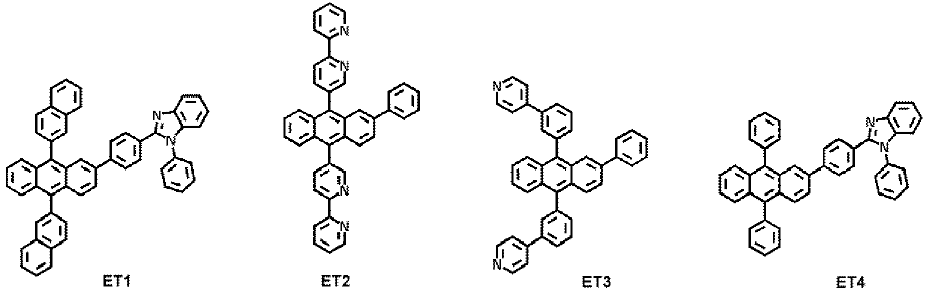

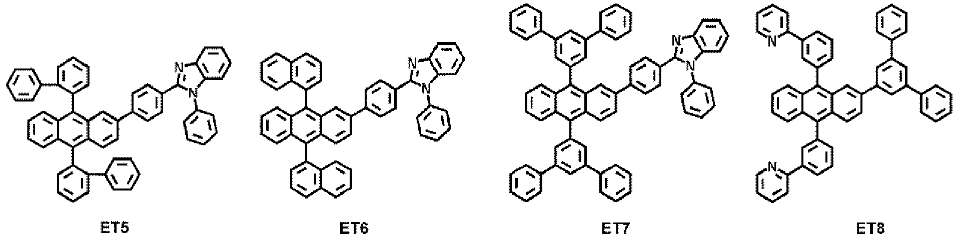

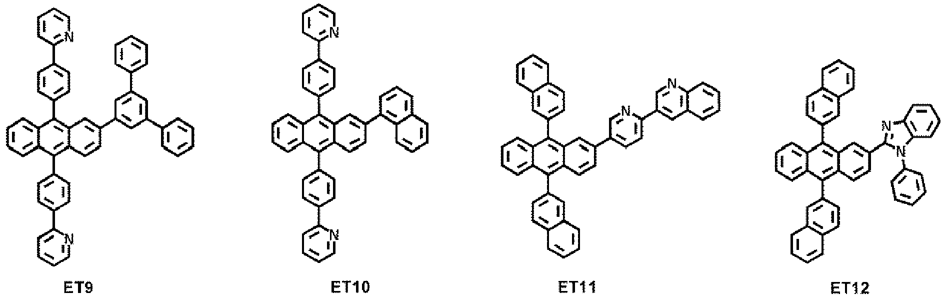

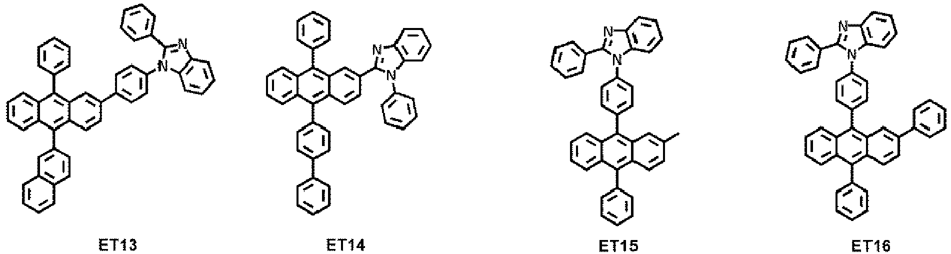

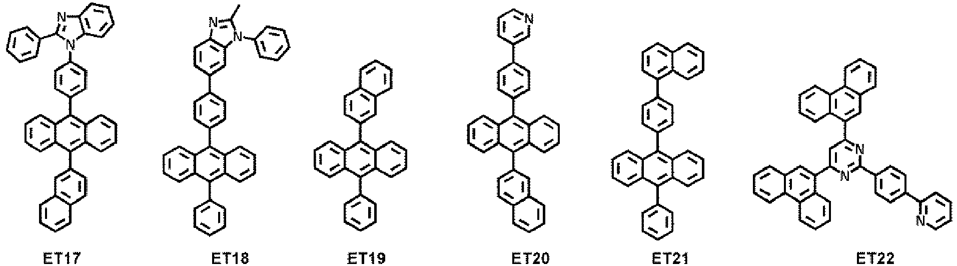

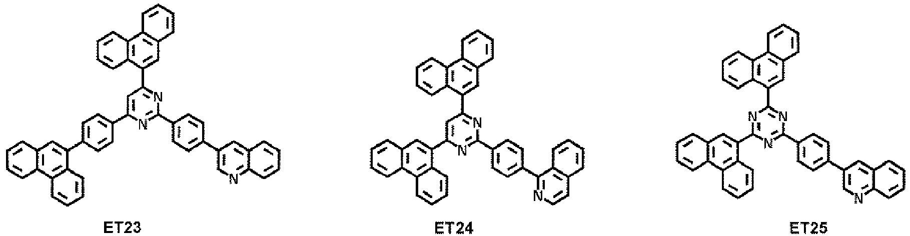

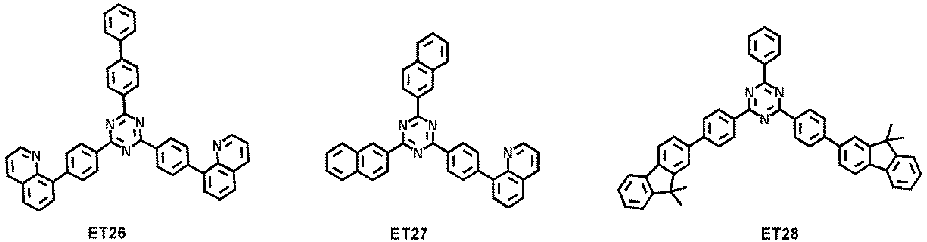

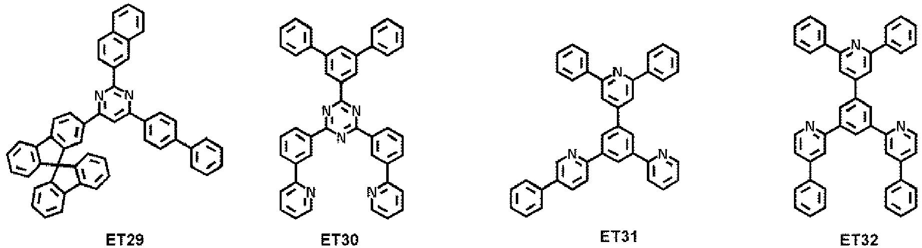

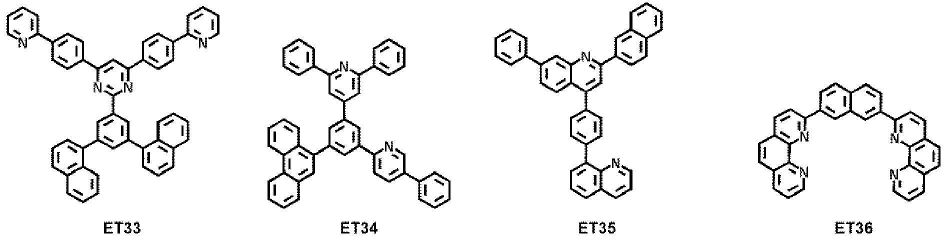

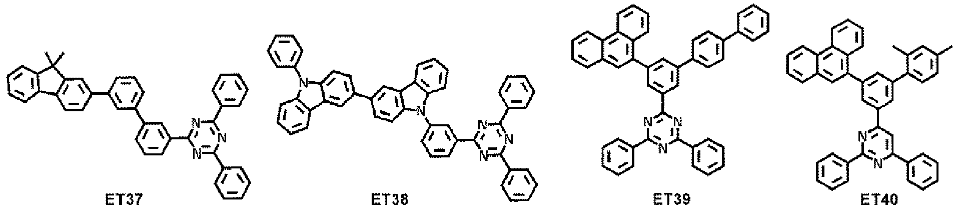

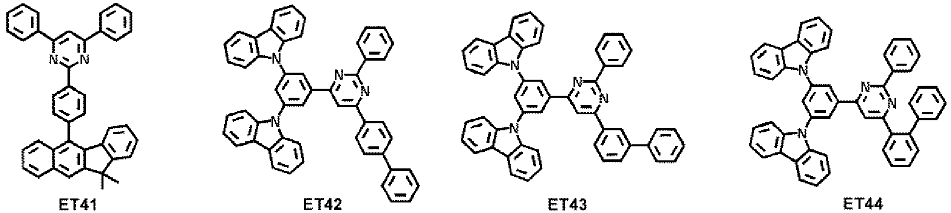

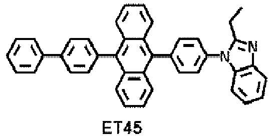

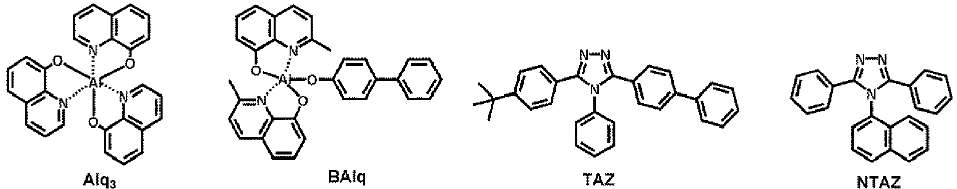

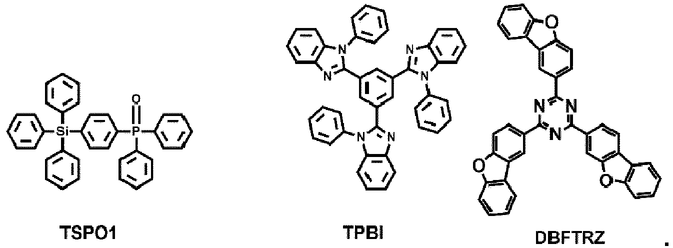

A thickness of the electron transport region may be from about 100 Å to about 5,000 Å, for example, about 160 Å to about 4,000 Å. When the electron transport region includes a buffer layer, a hole blocking layer, an electron control layer, an electron transport layer, or one or more combinations thereof, a thickness of the buffer layer, the hole blocking layer, or the electron control layer may be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thickness of the buffer layer, the hole blocking layer, the electron control layer, the electron transport layer, and/or the electron transport layer are within these ranges, satisfactory (suitable) electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or one or more combinations thereof.

For example, the metal-containing material may include a Li complex. The Li complex may include, for example, Compound ET-D1 (LiQ) or ET-D2:

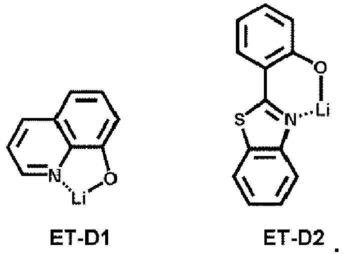

The electron transport region may include an electron injection layer that facilitates the injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron injection layer may include an alkali metal, alkaline earth metal, a rare earth metal, an alkali metal-containing compound, alkaline earth metal-containing compound, a rare earth metal-containing compound, an alkali metal complex, an alkaline earth metal complex, a rare earth metal complex, or one or more combinations thereof.

The alkali metal may include Li, Na, K, Rb, Cs, or one or more combinations thereof. The alkaline earth metal may include Mg, Ca, Sr, Ba, or one or more combinations thereof. The rare earth metal may include Sc, Y, Ce, Tb, Yb, Gd, or one or more combinations thereof.

The alkali metal-containing compound, the alkaline earth metal-containing compound, and the rare earth metal-containing compound may be oxides, halides (for example, fluorides, chlorides, bromides, or iodides), or tellurides of the alkali metal, the alkaline earth metal, and the rare earth metal, or one or more combinations thereof.

The alkali metal-containing compound may include: alkali metal oxides, such as Li₂O, Cs₂O, or K₂O; alkali metal halides, such as LiF, NaF, CsF, KF, Lil, Nal, Csl, or KI; or one or more combinations thereof. The alkaline earth metal-containing compound may include an alkaline earth metal oxide, such as BaO, SrO, CaO, BaₓSr₁₋ₓO (wherein 0<x<1), BaₓCa₁₋ₓO (wherein 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or one or more combinations thereof. In an embodiment, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth-metal complex, and the rare earth metal complex may include i) one of metal ions of the alkali metal, the alkaline earth metal, and the rare earth metal and ii) a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or one or more combinations thereof.

In an embodiment, the electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or one or more combinations thereof, as described above. In one or more embodiments, the electron injection layer may further include an organic material (for example, a compound represented by Formula 601).

In one or more embodiments, the electron injection layer may include (e.g., consist of): i) an alkali metal-containing compound (for example, an alkali metal halide); or ii) a) an alkali metal-containing compound (for example, an alkali metal halide), and b) an alkali metal, an alkaline earth metal, a rare earth metal, or one or more combinations thereof. For example, the electron injection layer may be a KI:Yb co-deposited layer, an RbI:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or one or more combinations thereof may be substantially uniformly or non-uniformly dispersed in a matrix including the organic material.

A thickness of the electron injection layer may be in a range of about 1 Å to about 100 Å, and, for example, about 3 Å to about 90 Å. When the thickness of the electron injection layer is within the ranges above, satisfactory (suitable) electron injection characteristics may be obtained without a substantial increase in driving voltage.

### Second electrode 150

The second electrode 150 may be arranged on the interlayer 130 having a structure as described above. The second electrode 150 may be a cathode, which is an electron injection electrode, and as a material for forming the second electrode 150, a metal, an alloy, an electrically conductive compound, or one or more combinations thereof, each having a low-work function, may be utilized.

The second electrode 150 may include Li, Ag, Mg, Al, Al-Li, Ca, Mg-In, Mg-Ag, Yb, Ag-Yb, ITO, IZO, or one or more combinations thereof. The second electrode 150 may be a transmissive electrode, a semi-transmissive electrode, or a reflective electrode.

The second electrode 150 may have a single-layered structure or a multi-layered structure including a plurality of layers.

### Capping layer

A first capping layer may be located outside the first electrode 110, and/or a second capping layer may be located outside the second electrode 150. In particular, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in an emission layer of the interlayer 130 of the light-emitting device 10 may be extracted toward the outside through the first electrode 110 which is a semi-transmissive electrode or a transmissive electrode, and the first capping layer. Light generated in an emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved (increased).

Each of the first capping layer and the second capping layer may include a material having a refractive index of 1.6 or more (at the wavelength of 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include carbocyclic compounds, heterocyclic compounds, amine group-containing compounds, porphyrin derivatives, phthalocyanine derivatives, naphthalocyanine derivatives, alkali metal complexes, alkaline earth metal complexes, or one or more combinations thereof. Optionally, the carbocyclic compound, the heterocyclic compound, and the amine group-containing compound may be substituted with a substituent including O, N, S, Se, Si, F, Cl, Br, I, or one or more combinations thereof. In one or more embodiments, at least one selected from the first capping layer and the second capping layer may each independently include an amine group-containing compound.

For example, at least one selected from the first capping layer and the second capping layer may each independently include a compound represented by Formula 201, a compound represented by Formula 202, or any combination thereof.

In an embodiment, at least one selected from the first capping layer and the second capping layer may each independently include at least one of Compounds HT28 to HT33, at least one of Compounds CP1 to CP6, β-NPB, P4, or one or more combinations thereof:

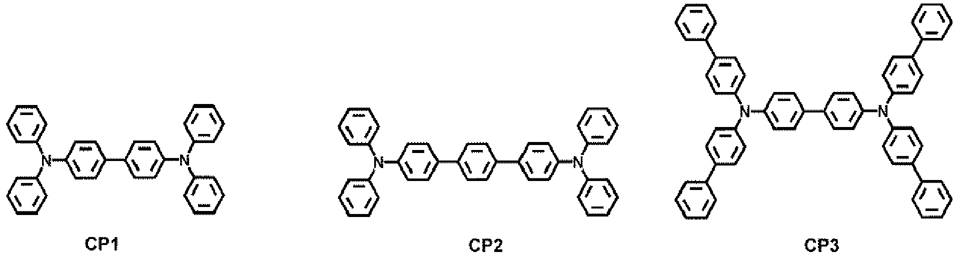

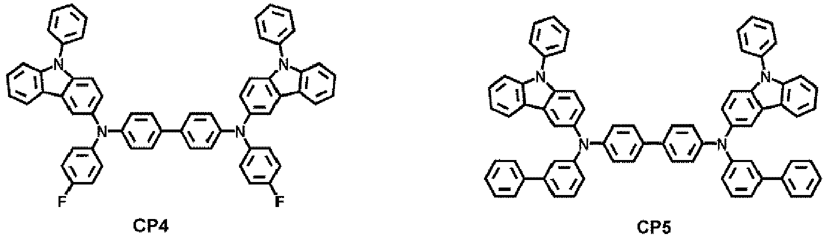

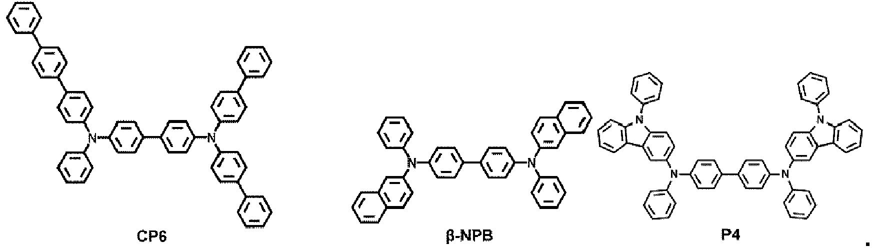

### Electronic apparatus

The light-emitting device may be included in one or more suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be located in at least one traveling direction of light emitted from the light-emitting device. For example, the light emitted from the light-emitting device may be blue light or white light. For details on the light-emitting device, related description provided above may be referred to. In one or more embodiments, the color conversion layer may include a quantum dot. The quantum dot may be, for example, a quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be located among the subpixel areas to define each of the subpixel areas.

The color filter may further include a plurality of color filter areas and light-shielding patterns located among the color filter areas, and the color conversion layer may further include a plurality of color conversion areas and light-shielding patterns located among the color conversion areas.

The plurality of color filter areas (or the plurality of color conversion areas) may include a first area emitting first color light, a second area emitting second color light, and/or a third area emitting third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In particular, the first area may include a red quantum dot, the second area may include a green quantum dot, and the third area may not include (e.g., may exclude) a quantum dot. For more details on the quantum dot, related descriptions provided herein may be referred to. The first area, the second area, and/or the third area may each include a scatterer.

For example, the light-emitting device may emit first light, the first area may absorb the first light to emit first-first color light, the second area may absorb the first light to emit second-first color light, and the third area may absorb the first light to emit third-first color light. In this regard, the first-first color light, the second-first color light, and the third-first color light may have different maximum emission wavelengths. In particular, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer, wherein either the source electrode or the drain electrode may be electrically connected to either the first electrode or the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be located between the color conversion layer and/or color filter and the light-emitting device. The sealing portion allows light from the light-emitting device to be extracted to the outside, and concurrently (e.g., simultaneously) prevents (reduces) ambient air and moisture from penetrating into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

Various suitable functional layers may be additionally located on the sealing portion, in addition to the color filter and/or the color conversion layer, according to the use of the electronic apparatus. Examples of the functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, and/or the like).

The authentication apparatus may further include, in addition to the light-emitting device as described above, a biometric information collector.

The electronic apparatus may be applied to one or more suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

### Description of FIGS. 2 and 3

FIG. 2 is a cross-sectional view showing a light-emitting apparatus according to an embodiment of the present disclosure.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, and/or a metal substrate. A buffer layer 210 may be located on the substrate 100. The buffer layer 210 may prevent or reduce penetration of impurities through the substrate 100 and may provide a flat surface on the substrate 100.

A TFT may be located on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be located on the activation layer 220, and the gate electrode 240 may be located on the gate insulating film 230.

An interlayer insulating film 250 may be located on the gate electrode 240. The interlayer insulating film 250 may be located between the gate electrode 240 and the source electrode 260 and between the gate electrode 240 and the drain electrode 270, to insulate the gate electrode from the source electrode and to insulate the gate electrode from the drain electrode.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be located in contact with the exposed portions of the source region and the drain region of the activation layer 220.

The TFT 200 is electrically connected to a light-emitting device to drive the light-emitting device, and is covered and protected by a passivation layer 280. The passivation layer 280 may include an inorganic insulating film, an organic insulating film, or any combination thereof. A light-emitting device is provided on the passivation layer 280. The light-emitting device may include a first electrode 110, an interlayer 130, and a second electrode 150.

The first electrode 110 may be located on the passivation layer 280. The passivation layer 280 may be located to expose a portion of the drain electrode 270, not fully covering the drain electrode 270, and the first electrode 110 may be located to be connected to the exposed portion of the drain electrode 270.

A pixel defining layer 290 including an insulating material may be located on the first electrode 110. The pixel defining layer 290 may expose a certain region of the first electrode 110, and an interlayer 130 may be formed in the exposed region of the first electrode 110. The pixel defining layer 290 may be a polyimide or polyacrylic organic film. At least some layers of the interlayer 130 may extend beyond the upper portion of the pixel defining layer 290 to be located in the form of a common layer.

The second electrode 150 may be located on the interlayer 130, and a capping layer 170 may be additionally formed on the second electrode 150. The capping layer 170 may be formed to cover the second electrode 150.

The encapsulation portion 300 may be located on the capping layer 170. The encapsulation portion 300 may be located on a light-emitting device to protect the light-emitting device from moisture or oxygen (e.g., reduce the amount of moisture and/or oxygen). The encapsulation portion 300 may include: an inorganic film including silicon nitride (SiNx), silicon oxide (SiOx), indium tin oxide, indium zinc oxide, or one or more combinations thereof; an organic film including polyethylene terephthalate, polyethylene naphthalate, polycarbonate, polyimide, polyethylene sulfonate, polyoxymethylene, polyarylate, hexamethyldisiloxane, an acrylic-based resin (for example, polymethyl methacrylate, polyacrylic acid, and/or the like), an epoxy-based resin (for example, aliphatic glycidyl ether (AGE), and/or the like), or one or more combinations thereof; or any combination of the inorganic films and the organic films.

FIG. 3 shows a cross-sectional view showing an electronic apparatus according to an embodiment of the present disclosure.

The electronicapparatus 190 of FIG. 3 is the same as the electronic apparatus 180 of FIG. 2, except that a light-shielding pattern 500 and a functional region 400 are additionally located on the encapsulation portion 300. The functional region 400 may be i) a color filter area, ii) a color conversion area, or iii) a combination of the color filter area and the color conversion area. In an embodiment, the light-emitting device included in the electronic apparatus 190 of FIG. 3 may be a tandem light-emitting device.

### Manufacturing method

The layers included in the hole transport region, the emission layer, and the layers included in the electron transport region may be formed in a certain region by utilizing one or more suitable methods such as vacuum deposition, spin coating, casting, Langmuir-Blodgett (LB) deposition, ink-jet printing, laser-printing, laser-induced thermal imaging, and/or the like.

When layers including the hole transport region, an emission layer, and layers including the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of Terms

The term "C₃-C₆₀ carbocyclic group" as utilized herein refers to a cyclic group consisting of carbon only as a ring-forming atom and having three to sixty carbon atoms, and the term "C₁-C₆₀ heterocyclic group" as utilized herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the C₁-C₆₀ heterocyclic group has 3 to 61 ring-forming atoms.

The term "cyclic group" as utilized herein may include the C₃-C₆₀ carbocyclic group, and the C₁-C₆₀ heterocyclic group.

The term "π electron-rich C₃-C₆₀ cyclic group" as utilized herein refers to a cyclic group that has three to sixty carbon atoms and does not include *-N=*' as a ring-forming moiety, and the term "π electron-deficient nitrogen-containing C₁-C₆₀ cyclic group" as utilized herein refers to a heterocyclic group that has one to sixty carbon atoms and includes *-N=*' as a ring-forming moiety.

For example,
the C₃-C₆₀ carbocyclic group may be i) group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) group T2, ii) a condensed cyclic group in which two or more groups T2 are condensed with each other, or iii) a condensed cyclic group in which at least one group T2 and at least one group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
the π electron-rich C₃-C₆₀ cyclic group may be i) group T1, ii) a condensed cyclic group in which two or more groups T1 are condensed with each other, iii) group T3, iv) a condensed cyclic group in which two or more groups T3 are condensed with each other, or v) a condensed cyclic group in which at least one group T3 and at least one group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like),
the π electron-deficient nitrogen-containing C₁-C₆₀ cyclic group may be i) group T4, ii) a condensed cyclic group in which two or more groups T4 are condensed with each other, iii) a condensed cyclic group in which at least one group T4 and at least one group T1 are condensed with each other, iv) a condensed cyclic group in which at least one group T4 and at least one group T3 are condensed with each other, or v) a condensed cyclic group in which at least one group T4, at least one group T1, and at least one group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),
group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
group T3 may be a furan group, a thiophene group, a 1H-pyrrole group, a silole group, or a borole group, and
group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ cyclic group" as utilized herein refer to a group condensed to any cyclic group, a monovalent group, or a polyvalent group (for example, a divalent group, a trivalent group, a tetravalent group, and/or the like) according to the structure of a formula for which the corresponding term is utilized. For example, the "benzene group" may be a benzo group, a phenyl group, a phenylene group, and/or the like, which may be easily understood by one of ordinary skill in the art according to the structure of a formula including the "benzene group."

Examples of the monovalent C₃-C₆₀ carbocyclic group and the monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and/or a monovalent non-aromatic condensed heteropolycyclic group. Examples of the divalent C₃-C₆₀ carbocyclic group and the divalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and/or a divalent non-aromatic condensed heteropolycyclic group.

The term "C₁-C₆₀ alkyl group" as utilized herein refers to a linear or branched aliphatic hydrocarbon monovalent group that has one to sixty carbon atoms, and specific examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as utilized herein refers to a divalent group having the same structure as the C₁-C₆₀ alkyl group.

The term "C₂-C₆₀ alkenyl group" as utilized herein refers to a monovalent hydrocarbon group having at least one carbon-carbon double bond in the middle or at the terminus of the C₂-C₆₀ alkyl group, and examples thereof are an ethenyl group, a propenyl group, and a butenyl group. The term "C₂-C₆₀ alkenylene group" as utilized herein refers to a divalent group having the same structure as the C₂-C₆₀ alkenyl group.

The term "C₂-C₆₀ alkynyl group" as utilized herein refers to a monovalent hydrocarbon group having at least one carbon-carbon triple bond in the middle or at the terminus of the C₂-C₆₀ alkyl group, and examples thereof include an ethynyl group and a propynyl group. The term "C₂-C₆₀ alkynylene group" as utilized herein refers to a divalent group having the same structure as the C₂-C₆₀ alkynyl group.

The term "C₁-C₆₀ alkoxy group" as utilized herein refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₃-C₁₀ cycloalkyl group" as utilized herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group" as utilized herein refers to a divalent group having the same structure as the C₃-C₁₀ cycloalkyl group.

The term "C₁-C₁₀ heterocycloalkyl group" as utilized herein refers to a monovalent cyclic group of 1 to 10 carbon atoms, further including, in addition to carbon atoms, at least one heteroatom, as ring-forming atoms, and specific examples are a 1,2,3,4-oxatriazolidinyl group, a tetrahydrofuranyl group, and a tetrahydro thiophenyl group. The term "C₁-C₁₀ heterocycloalkylene group" as utilized herein refers to a divalent group having the same structure as the C₁-C₁₀ heterocycloalkyl group.

The term C₃-C₁₀ cycloalkenyl group utilized herein refers to a monovalent cyclic group that has three to ten carbon atoms and at least one carbon-carbon double bond in the ring thereof and no aromaticity, and specific examples thereof are a cyclopentenyl group, a cyclohexenyl group, and a cycloheptenyl group. The term "C₃-C₁₀ cycloalkenylene group" as utilized herein refers to a divalent group having the same structure as the C₃-C₁₀ cycloalkenyl group.

The term "C₁-C₁₀ heterocycloalkenyl group" as utilized herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group include a 4,5-dihydro-1,2,3,4-oxatriazolyl group, a 2,3-dihydrofuranyl group, and/or a 2,3-dihydrothiophenyl group. The term "C₁-C₁₀ heterocycloalkenylene group" as utilized herein refers to a divalent group having the same structure as the C₁-C₁₀ heterocycloalkenyl group.

The term "C₆-C₆₀ aryl group" as utilized herein refers to a monovalent group having a carbocyclic aromatic system of 6 to 60 carbon atoms, and the term "C₆-C₆₀ arylene group" as utilized herein refers to a divalent group having a carbocyclic aromatic system of 6 to 60 carbon atoms. Examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, a fluorenyl group, a spirobifluorenyl group, a benzofluorenyl group, and/or the like. When the C₆-C₆₀ aryl group and the C₆-C₆₀ arylene group each include two or more rings, the rings may be condensed with each other.

The term "C₁-C₆₀ heteroaryl group" as utilized herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as utilized herein refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a naphthyridinyl group, an azafluorenyl group, a carbazolyl group, an azacarbazolyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, and/or the like. When the C₁-C₆₀ heteroaryl group and the C₁-C₆₀ heteroarylene group each include two or more rings, the rings may be condensed with each other.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group are an indenyl group, an indenophenanthrenyl group, and/or an indeno anthracenyl group. The term "divalent non-aromatic condensed polycyclic group" as utilized herein refers to a divalent group having the same structure as the monovalent non-aromatic condensed polycyclic group described above.

The term "monovalent non-aromatic condensed heteropolycyclic group" as utilized herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure. Examples of the monovalent non-aromatic condensed heteropolycyclic group include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a dibenzosilolyl group, a dibenzothiophenyl group, a dibenzofuranyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group.

The term "divalent non-aromatic condensed heteropolycyclic group" as utilized herein refers to a divalent group having the same structure as the monovalent non-aromatic condensed heteropolycyclic group described above.

The term "C₆-C₆₀ aryloxy group" as utilized herein indicates -OA₁₀₂ (wherein A₁₀₂ is a C₆-C₆₀ aryl group), and the term "C₆-C₆₀ arylthio group" as utilized herein indicates -SA₁₀₃ (wherein A₁₀₃ is a C₆-C₆₀ aryl group).

The term "C₇₋C₆₀ arylalkyl group" as utilized herein refers to -A₁₀₄A₁₀₅ (where A₁₀₄ may be a C₁-C₅₄ alkylene group, and A₁₀₅ may be a C₆-C₅₉ aryl group), and the term C₂-C₆₀ heteroarylalkyl group" as utilized herein refers to -A₁₀₆A₁₀₇ (where A₁₀₆ may be a C₁-C₅₉ alkylene group, and A₁₀₇ may be a C₁-C₅₉ heteroaryl group).

The term "R₁₀ₐ" as utilized herein refers to:
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or one or more combinations thereof,
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or one or more combinations thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃ and Q₃₁ to Q₃₃ utilized herein may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or one or more combinations thereof; a C₇₋C₆₀ arylalkyl group; or a C₂-C₆₀ heteroarylalkyl group.

The term "heteroatom" as utilized herein refers to any atom other than a carbon atom. Examples of the heteroatom are O, S, N, P, Si, B, Ge, Se, and/or one or more combinations thereof.

The term "third-row transition metal" as utilized herein includes hafnium (Hf), tantalum (Ta), tungsten (W), rhenium (Re), osmium (Os), iridium (Ir), platinum (Pt), gold (Au), and/or the like.

"Ph" as utilized herein refers to a phenyl group, "Me" as utilized herein refers to a methyl group, "Et" as utilized herein refers to an ethyl group, "ter-Bu" or "Bu^{t}" as utilized herein refers to a tert-butyl group, and "OMe" as utilized herein refers to a methoxy group.

The term "biphenyl group" as utilized herein refers to "a phenyl group substituted with a phenyl group." In other words, the "biphenyl group" is a substituted phenyl group having a C₆-C₆₀ aryl group as a substituent.

The term "terphenyl group" as utilized herein refers to "a phenyl group substituted with a biphenyl group". In other words, the "terphenyl group" is a substituted phenyl group having, as a substituent, a C₆-C₆₀ aryl group substituted with a C₆-C₆₀ aryl group.

*, *', *" and *‴ as utilized herein, unless defined otherwise, each refer to a binding site to a neighboring atom in a corresponding formula or moiety.

Hereinafter, compounds according to embodiments and light-emitting devices according to embodiments will be described in more detail with reference to the following synthesis examples and examples. The wording "B was utilized instead of A" as utilized in describing Synthesis Examples refers to that an identical molar equivalent of B was utilized in place of A.

### Examples

### Example 1

As an anode, a glass substrate on which 15 Ω/cm² (1,200 Å) ITO electrode (available from Corning Co., Ltd) was formed was cut to a size of 50 mm×50 mm×0.7 mm, sonicated in isopropyl alcohol and pure water for 10 minutes in each solvent (i.e., in isopropyl alcohol for 10 minutes and pure water for 10 minutes), and cleaned by exposure to ultraviolet rays and ozone for 10 minutes. Then, the resultant substrate was mounted on a vacuum deposition apparatus.
m-MTDATA was deposited on the anode to form a hole injection layer having a thickness of about 40 Å, and NPB was deposited on the hole injection layer to form a hole transport layer having a thickness of about 100 Å.

Compound 1-1 (as a first-first host) and Compound 2-1 (as a first-second host) were co-deposited at a weight ratio of 1:1 on the hole transport layer to form a first emission layer having a thickness of 50 Å. On the first emission layer, Compound 1-1 (as a second-first host) and Compound 2-2 (as a second-second host) at a weight ratio of 1:1 and Compound 3-1 (as a dopant) at a ratio of 10 wt % with respect to the total weight of the second-first host and the second-second host were concurrently (e.g., simultaneously) co-deposited to form a second emission layer having a thickness of 400 Å.

Subsequently, DBFTRZ was deposited on the second emission layer to form a buffer layer having a thickness of 50 Å, ET1 was deposited on the buffer layer to form an electron transport layer having a thickness of 300 Å, and Mg was deposited on the electron transport layer to form a cathode having a thickness of 800 Å, thereby completing the manufacture of an organic light-emitting device.

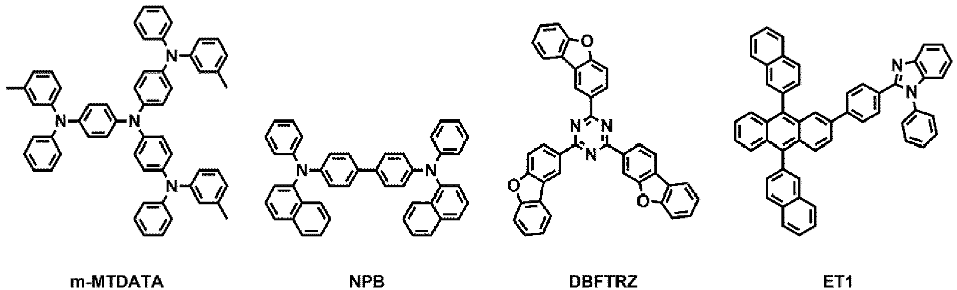

### Examples 2-1, 2-2, 3, 4-1 and 4-2, Comparative Examples 1, 3, 5-1, 5-2, 6-1 and 6-2, and Reference Example 1 to 6

Organic light-emitting devices were manufactured in substantially the same manner as in Example 1, except that compounds shown in Table 1 were utilized to form the first emission layer and the second emission layer. However, in ReferenceExamples 1 to 6, the emission layer was formed in a single-layered structure rather than a multi-layered structure.

### Evaluation Example 1

Regarding each of the organic light-emitting devices of Examples 1 to 6 and Comparative Examples 1 to 12, external quantum efficiency (EQE) at 1,000 cd/m² and lifespan (T95) were measured utilizing Keithley MU 236 and a luminance meter PR650.

In some embodiments, regarding each emission layer of the organic light-emitting devices of **Examples 1, 2-1, 2-2, 3, 4-1 and 4-2, Comparative Examples 1, 3, 5-1, 5-2, 6-1 and 6-2, and Reference Example 1 to 6,** a low-temperature (4 K) emission spectrum and a room temperature (300 K) emission spectrum were respectively measured utilizing a spectrophotometer. Then, in comparison with the room temperature emission spectrum, the starting point of the shortest wavelength of the spectrum observed only from the low-temperature emission spectrum was analyzed to evaluate triplet energy levels (T₁). These values are shown in Table 1.

**Table 1**

| No. | First emission layer | | Second emission layer | | Extern al Quantu m Efficien cy (EQE) (%) | Lifespa n (T₉₅) |
|---|---|---|---|---|---|---|
| | Compound (first-first host+ first-second host) | Triplet energy level (eV) of first host | Compound (second-first host+ second-second host+ dopant) | Triplet energy level (eV) of second host | | |
| Exam ple 1 | Compound 1-1 + | 2.83 | Compound 1-1+ | 2.80 | 27.9 % | 22 h |
| | Compound 2-1 | | Compound 2-2+ | | | |
| | | | Compound 3-1 | | | |
| Comp arativ e Exam ple 1 | Compound 1-1 + | 2.71 | Compound 1-1+ | 2.80 | 25.1 % | 12 h |
| | Compound 2-3 | | Compound 2-2+ | | | |
| | | | Compound 3-1 | | | |
| Refer ence Exam ple 1 | - | - | Compound 1-1+ | 2.80 | 27.6 % | 20 h |
| | | | Compound 2-2+ | | | |
| | | | Compound 3-1 | | | |
| Exam ple 2-1 | Compound 1-1 + | 2.83 | Compound 1-1+ | 2.71 | 26.8 % | 24 h |
| | Compound 2-1 | | Compound 2-3+ | | | |
| | | | Compound 3-1 | | | |
| Exam ple 2-2 | Compound 1-1 + | 2.80 | Compound 1-1+ | 2.71 | 26.9 % | 23 h |
| | Compound 2-2 | | Compound 2-3+ | | | |
| | | | Compound 3-1 | | | |
| Refer ence Exam ple 2 | - | - | Compound 1-1+ | 2.71 | 26.3 % | 18 h |
| | | | Compound 2-3+ | | | |
| | | | Compound 3-1 | | | |
| Exam ple 3 | Compound 1-1 + | 2.83 | Compound 1-1+ | 2.80 | 32.0 % | 42 h |
| | Compound 2-1 | | Compound 2-2+ | | | |
| | | | Compound 3-2 | | | |
| Comp arativ e Exam ple 3 | Compound 1-1 + | 2.71 | Compound 1-1+ | 2.80 | 29.4 % | 21 h |
| | Compound 2-3 | | Compound 2-2+ | | | |
| | | | Compound 3-2 | | | |
| Refer ence Exam ple 3 | - | - | Compound 1-1+ | 2.80 | 31.8 % | 33 h |
| | | | Compound 2-2+ | | | |
| | | | Compound 3-2 | | | |
| Exam ple 4-1 | Compound 1-1 + | 2.83 | Compound 1-1+ | 2.71 | 31.4 % | 34 h |
| | | | Compound 2-3+ | | | |
| | Compound 2-1 | | Compound 3-2 | | | |
| Exam ple 4-2 | Compound 1-1 + | 2.80 | Compound 1-1+ | 2.71 | 30.1 % | 34 h |
| | Compound 2-2 | | Compound 2-3+ | | | |
| | | | Compound 3-2 | | | |
| Refer ence Exam ple 4 | - | - | Compound 1-1+ | 2.71 | 29.9 % | 30 h |
| | | | Compound 2-3+ | | | |
| | | | Compound 3-2 | | | |
| Comp arativ e Exam ple 5-1 | Compound 1-1 + | 2.80 | Compound 1-1+ | 2.83 | 32.9 % | 33 h |
| | Compound 2-2 | | Compound 2-1+ | | | |
| | | | Compound 3-2 | | | |
| Comp arativ e Exam ple 5-2 | Compound 1-1 + | 2.71 | Compound 1-1+ | 2.83 | 30.3 % | 25 h |
| | Compound 2-3 | | Compound 2-1+ | | | |
| | | | Compound 3-2 | | | |
| Refer ence | - | - | Compound 1-1+ | 2.83 | 33.6 % | 38 h |
| | | | Compound 2-1+ | | | |
| Exam ple 5 | | | Compound 3-2 | | | |
| Comp arativ e Exam ple 6-1 | Compound 1-1 + | 2.80 | Compound 1-1+ | 2.83 | 27.5 % | 20 h |
| | Compound 2-2 | | Compound 2-1+ | | | |
| | | | Compound 3-1 | | | |
| Comp arativ e Exam ple 6 | Compound 1-1 + | 2.71 | Compound 1-1+ | 2.83 | 23.8 % | 9 h |
| | Compound 2-3 | | Compound 2-1+ | | | |
| | | | Compound 3-1 | | | |
| Refer ence Exam ple 6 | - | - | Compound 1-1+ | 2.83 27.9 % 21 h | | |
| | | | Compound 2-1+ | | | |
| | | | Compound 3-1 | | | |

Referring to Table 1, it was confirmed that the organic light-emitting devices of Examples 1, 2-1, 2-2, 3, 4-1 and 4-2 having a multi-layered structure of the first emission layer and the second emission layer and satisfied a specific triplet energy condition between the first emission layer and the second emission layer each showed long lifespan and improved external quantum efficiency, compared to the organic light-emitting devices of Reference Examples 1 to 4 including the emission layer in a single layer and Comparative Example 1 and 3 including a multi-layered structure of the first emission layer and the second emission layer, and not satisfying the specific triplet energy condition between the first emission layer and the second emission layer..

In some embodiments, it was confirmed that the organic light-emitting devices of Comparative Example 5-1 to 5-2, and 6-1 to 6-2 including a multi-layered structure of the first emission layer and the second emission layer, and not satisfying a specific triplet energy condition between the first emission layer and the second emission layer showed a short lifespan and deteriorated (decreased) external quantum efficiency, compared to the organic light-emitting devices of Reference Examples 5 and 6 including the emission layer in a single layer and including same host and dopant in second emission layer.

According to the one or more embodiments, in a light-emitting device, a first emission layer may include a first host including a first-first host and a first-second host, but may not include (e.g., may exclude) a dopant; and a second emission layer may include a second host and a dopant, the second host including a second-first host and a second-second host. The first-first host and the first-second host may be different from each other, and the second-first host and the second-second host may be different from each other. A triplet energy level of the first host (T_{H1}) may be greater than a triplet energy level of the second host (T_{H2}), and thus the migration of triplet excitons formed in the first emission layer to the second emission layer may be promoted, whereas the migration of triplet excitons formed in the second emission layer to the first emission layer may be inhibited, thereby having excellent or suitable efficiency and long lifespan. In this regard, an electronic apparatus having high efficiency and long lifespan may be prepared.

The use of "may" when describing embodiments of the present disclosure refers to "one or more embodiments of the present disclosure."

As used herein, the term "substantially," "about," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, ± 20%, ± 10%, or ± 5% of the stated value.

Also, any numerical range recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this disclosure is intended to include all higher numerical limitations subsumed therein. Accordingly, Applicant reserves the right to amend this disclosure, including the claims, to expressly recite any sub-range subsumed within the ranges expressly recited herein.

The electronic apparatus or any other relevant devices or components according to embodiments of the present disclosure described herein may be implemented utilizing any suitable hardware, firmware (e.g., an application-specific integrated circuit), software, or a combination of software, firmware, and hardware. For example, the various components of the apparatus may be formed on one integrated circuit (IC) chip or on separate IC chips. Further, the various components of the apparatus may be implemented on a flexible printed circuit film, a tape carrier package (TCP) or a printed circuit board (PCB), or formed on one substrate. Further, the various components of the apparatus may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only and not for purposes of limitation. Descriptions of features or aspects within each embodiment should typically be considered as available for other similar features or aspects in other embodiments.

## Claims

1. A light-emitting device (10) comprising:
a first electrode (110);
a second electrode (150) facing the first electrode (110); and
an interlayer (130) between the first electrode (110) and the second electrode (150) and comprising an emission layer,
wherein,
the emission layer comprises a first emission layer and a second emission layer,
the first emission layer comprises a first host (T_{H1}) comprising a first-first host and a first-second host, but does not comprise a dopant,
the second emission layer comprises a second host (T_{H2}) and a dopant, the second host (T_{H2}) comprising a second-first host and a second-second host,
the first-first host and the first-second host are different from each other,
the second-first host and the second-second host are different from each other, and
a triplet energy level (eV) of the first host (T_{H1}) is greater than a triplet energy level (eV) of the second host (T_{H2}).

2. The light-emitting device (10) of claim 1, wherein Condition 1 or Condition 2 is satisfied:
Condition 1
the first emission layer is between the first electrode (110) and the second emission layer, and
the second emission layer is between the first emission layer and the second electrode (150); and
Condition 2
the first emission layer is between the second electrode (150) and the second emission layer, and
the second emission layer is between the first emission layer and the first electrode (110).

3. The light-emitting device (10) of at least one of claims 1 or 2, wherein.
the interlayer (130) further comprises a hole transport region between the first electrode (110) and the emission layer and an electron transport region between the emission layer and the second electrode (150),
the hole transport region comprises a hole injection layer, a hole transport layer, an emission auxiliary layer, an electron blocking layer, or any combination thereof, and
the electron transport region comprises a buffer layer (210), a hole blocking layer, an electron control layer, an electron transport layer, an electron injection layer, or any combination thereof.

4. The light-emitting device (10) of at least one of claims 2 or 3, wherein Condition 1-1 or Condition 2-1 is satisfied:
Condition 1-1
the first emission layer is between a hole transport region and the second emission layer, and the second emission layer is between an electron transport region and the first emission layer; and
Condition 2-1
the first emission layer is between the electron transport region and the second emission layer, and the second emission layer is between the hole transport region and the first emission layer.

5. The light-emitting device (10) of at least one of claims 1 to 4, wherein a thickness of the first emission layer is smaller than a thickness of the second emission layer.

6. The light-emitting device (10) of at least one of claims 1 to 5, wherein,
a thickness of the first emission layer is in a range of about 50 Å to about 150 Å, and
a thickness of the second emission layer is in a range of about 150 Å to about 450 Å.

7. The light-emitting device (10) of at least one of claims 1 to 6, wherein the emission layer is configured to emit blue light.

8. The light-emitting device (10) of claim 7, wherein the blue light has a maximum emission wavelength in a range of about 400 nm to about 490 nm.

9. The light-emitting device (10) of at least one of claims 1 to 8, wherein the first emission layer is in direct contact with the second emission layer.

10. The light-emitting device (10) of at least one of claims 1 to 9, wherein triplet excitons formed in the first emission layer are configured to migrate from the first emission layer to the second emission layer.

11. The light-emitting device (10) of at least one of claims 1 to 10, wherein the first-first host, the first-second host, the second-first host, and the second-second host are each independently represented by Formula 1:
Formula 1 [Ar₁₁]c₁₁-[(L₁₁)ₐ₁₁-R₁₁]_{b11}
wherein, in Formula 1,
Ar₁₁ and L₁₁ are each independently a C₃-C₆₀ carbocyclic group unsubstituted or substituted with at least one R₁₀ₐ or a C₁-C₆₀ heterocyclic group unsubstituted or substituted with at least one R₁₀ₐ,
a11 and c11 are each an integer from 0 to 3,
R₁₁ is hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇₋C₆₀ arylalkyl group unsubstituted or substituted with at least one R₁₀ₐ, a C₂-C₆₀ heteroarylalkyl group unsubstituted or substituted with at least one R₁₀ₐ, -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂),
b11 is an integer from 1 to 5,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇₋C₆₀ arylalkyl group, a C₂-C₆₀ heteroarylalkyl group, -Si(Q₁₁₎(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁₎(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇₋C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇₋C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇₋C₆₀ arylalkyl group; or a C₂-C₆₀ heteroarylalkyl group.

12. The light-emitting device (10) of at least one of claims 1 to 11, wherein an electron-transporting moiety is comprised in:
one selected from the first-first host and the first-second host; and
one selected from the second-first host and the second-second host.

13. The light-emitting device (10) of claim 12, wherein the electron-transporting moiety comprises a cyano group, a fluorine, a π-electron-deficient nitrogen-containing cyclic group, or any combination thereof.

14. The light-emitting device (10) of at least one of claims 1 to 13, wherein,
the first-first host and the second-first host are each a hole-transporting host, and
the first-second host and the second-second host are each an electron-transport host.

15. The light-emitting device (10) of at least one of claims 1 to 14, wherein the dopant is a phosphorescent dopant.

16. The light-emitting device (10) of at least one of claims 1 to 15, wherein the dopant is represented by Formula 3:
Formula 3 M₃(L₃₁)ₐ₃₁(L₃₂)ₐ₃₂ 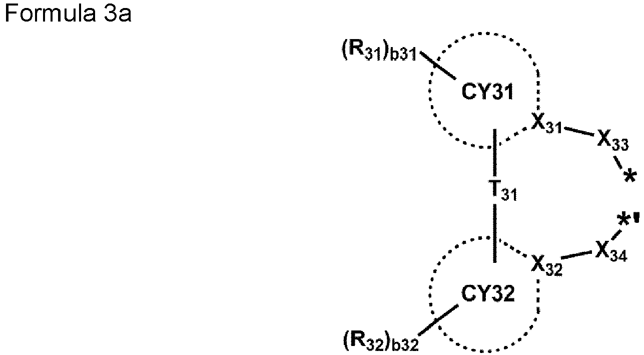
wherein, in Formulae 3 and 3a,
M₃ is iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm),
L₃₁ is a ligand represented by Formula 3a,
a31 is an integer from 1 to 3, wherein, when a31 is an integer from 2 or more, two or more of L₃, are identical to or different from each other,
L₃₂ is an organic ligand,
a32 is an integer from 1 to 3, wherein, when a32 is an integer from 2 or more, two or more of L₃₂ are identical to or different from each other,
when a31 is 2 or more, among two or more of L₃₁, two CY31 rings are optionally linked together via T₃₂ which is a linking group and two CY32 rings are optionally linked together via T₃₃ which is a linking group,
X₃₁ and X₃₂ are each independently nitrogen or carbon,
ring CY₃₁ and ring CY₃₂ are each independently a C₃-C₆₀ carbocyclic group or a C₁-C₆₀ heterocyclic group,
T₃₁ to T₃₃ are each independently a single bond, *"-O-*"', *"-S-*‴, *"-C(=O)-*‴, *"-N(Z₃₁)-*‴, *"-C(Z₃₁)(Z₃₂)-*m *"-C(Z₃₁)=C(Z₃₁)-*‴, *"-C(Z₃₁)=*‴, or *"=C=*‴,
*" and *‴ each indicate a binding site to a neighboring atom,
X₃₃ and X₃₄ are each independently a covalent bond, a coordinate bond, O, S, N(Z₃₃), B(Z₃₃), P(Z₃₃), C(Z₃₃)(Z₃₄), or Si(Z₃₃)(Z₃₄),
R₃₁, R₃₂, and Z₃₁ to Z₃₄ are each independently hydrogen, deuterium, -F, -Cl, - Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
b31 and b32 are each independently an integer from 0 to 10,
when b31 is an integer of 2 or more, two R₃₁(s) among two or more of R₃₁(s); two R₃₂(s) among two or more of R₃₂(s); or R₃₁ and R₃₂, are optionally linked to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
* and *' in Formula 3a each indicate a binding site to M₃ in Formula 3,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇₋C₆₀ arylalkyl group, a C₂-C₆₀ heteroarylalkyl group, -Si(Q₁₁₎(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇₋C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇₋C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇₋C₆₀ arylalkyl group; or a C₂-C₆₀ heteroarylalkyl group.

17. The light-emitting device (10) of claim 16, wherein, in Formula 3, M₃ is iridium(Ir) or platinum(Pt).

18. An electronic apparatus comprising the light-emitting device (10) of at least one of claims 1 to 17.

19. The electronic apparatus of claim 18, further comprising a thin-film transistor (TFT),
wherein,
the thin-film transistor (TFT) comprises a source electrode (260) and a drain electrode (270), and
the first electrode (110) of the light-emitting device (10) is electrically connected to either the source electrode (260) of the thin-film transistor (TFT) or the drain electrode (270) of the thin-film transistor (TFT).

20. The electronic apparatus of at least one of claims 18 or 19, further comprising a color filter, a quantum dot, a color conversion layer, a touch screen layer, a polarizing layer, or any combination thereof.
